# EUROPEAN PATENT APPLICATION

(11) **EP 4 475 173 A1**
(43) Date of publication of application: **11.12.2024**
(21) Application number: 24150310.1
(22) Date of filing: 04.01.2024
(51) Int. Cl.: H01L 21/8234, H01L 29/06, H01L 29/40, H01L 29/66, H01L 29/417, H01L 29/775, H01L 29/78, H01L 29/10

(54) **SEMICONDUCTOR DEVICE**

(30) Priority: 08.06.2023 KR 20230073507
(71) Applicant: Samsung Electronics Co., Ltd., Suwon-si, Gyeonggi-do 16677 (KR)
(72) Inventor: KIM, Jinbum, Suwon-si (KR); YANG, Guifu, Suwon-si (KR); YANG, Suk, Suwon-si (KR); LEE, Sangmoon, Suwon-si (KR); JANG, Sunguk, Suwon-si (KR); JANG, Sung-Hwan, Suwon-si (KR); CHOI, Wonhee, Suwon-si (KR)
(74) Representative: Marks & Clerk LLP

(57) **Abstract**

Provided is a semiconductor device including a lower pattern layer including a first semiconductor material; a first conductivity-type doped pattern layer disposed on the lower pattern layer and including a semiconductor material doped with a first conductivity-type impurity; a source/drain pattern disposed on the first conductivity-type doped pattern layer and including a semiconductor material doped with a second conductivity-type impurity different from the first conductivity-type impurity; a channel pattern including semiconductor patterns connected between the source/drain patterns, stacked apart from each other, and including a second semiconductor material different from the first semiconductor material; and a gate pattern disposed on the first conductivity-type doped pattern layer and between the source/drain patterns, and surrounding the channel pattern.

## Description

### BACKGROUND OF THE INVENTION

### (a) Field of the Invention

The present disclosure relates to a semiconductor device and a manufacturing method thereof.

### (b) Description of the Related Art

Semiconductors are materials belonging to an intermediate region between a conductor and an insulator, and refer to a material that conducts electricity under certain conditions. Various semiconductor devices, for example, memory devices, may be manufactured using these semiconductor materials. Such semiconductor devices may be used in various electronic devices.

As the electronics industry develops to a high degree, demands on the characteristics of semiconductor devices are gradually increasing. For example, demands for high reliability, high speed, and/or multifunctionality of semiconductor devices are gradually increasing. In order to satisfy these required characteristics, structures within semiconductor devices are becoming increasingly complex and integrated.

### SUMMARY OF THE INVENTION

In one aspect of the present disclosure, since an etch can be formed deeply even in a device with a reduced size, the problem of unetching the source/drain can be solved, and current leakage from a lower portion of the source/drain can be prevented. When a backside power distribution network (BSPDN) structure is applied, a semiconductor device can easily implement a structure (BSPDN bulk-less) in which all of the lower substrate is removed, through an etching selectivity.

A semiconductor device according to one aspect comprises a lower pattern layer including a first semiconductor material; a first conductivity-type doped pattern layer disposed on the lower pattern layer and including a semiconductor material doped with a first conductivity-type impurity; a source/drain pattern disposed on the first conductivity-type doped pattern layer and including a semiconductor material doped with a second conductivity-type impurity different from the first conductivity-type impurity; a channel pattern including semiconductor patterns connected between the source/drain patterns, stacked apart from each other, and including a second semiconductor material different from the first semiconductor material; and a gate pattern disposed on the first conductivity-type doped pattern layer and between the source/drain patterns, and surrounding the channel pattern. The semiconductor device may comprise one or more source/drain patterns. A source/drain pattern may comprise one or more source/drain structures. The gate pattern may be disposed on the first conductivity-type doped pattern layer and between the source/drain structures of the source/drain pattern, and surrounding the channel pattern.

The first semiconductor material may include silicon (Si), germanium (Ge), or a combination thereof, and carbon (C).

The first semiconductor material may include about 0 at% to about 31.5 at% of the germanium (Ge), greater than about 0 at% and less than or equal to about 2 at% of the carbon (C), and a balance amount of the silicon (Si).

The second semiconductor material may include silicon (Si), germanium (Ge), or a combination thereof.

The first conductivity-type impurity may be an n-type impurity, and the second conductivity-type impurity may be a p-type impurity.

The n-type impurity may include phosphorus (P), arsenic (As), antimony (Sb), or a combination thereof, and the p-type impurity may include boron (B), aluminum (Al), gallium (Ga), indium (In), or a combination thereof.

The first conductivity-type impurity may be a p-type impurity, and the second conductivity-type impurity may be an n-type impurity.

The n-type impurity may include phosphorus (P), arsenic (As), antimony (Sb), or a combination thereof, and p-type impurity may include boron (B), aluminum (Al), gallium (Ga), indium (In), or a combination thereof.

The first conductivity-type doped pattern layer may be an epitaxial layer.

The gate pattern may have a main gate portion disposed on the semiconductor patterns and sub-gate portions disposed between the semiconductor patterns.

The semiconductor device may further include an inner gate spacer disposed between the sub-gate portions of the gate pattern and the source/drain pattern.

A semiconductor device according to another aspect includes a lower pattern layer including a first semiconductor material; a first conductivity-type doped pattern layer disposed on the lower pattern layer and including a semiconductor material doped with a first conductivity-type impurity; a source/drain pattern disposed on the first conductivity-type doped pattern layer and including a semiconductor material doped with a second conductivity-type impurity different from the first conductivity-type impurity; a channel pattern including semiconductor patterns connected between the source/drain patterns, stacked apart from each other, and including a second semiconductor material different from the first semiconductor material; a gate pattern disposed on the first conductivity-type doped pattern layer and between the source/drain patterns, and surrounding the channel pattern; and a lower contact electrode disposed under the source/drain pattern and connected to the source/drain pattern by penetrating the lower pattern layer and the first conductivity-type doped pattern layer. The semiconductor device may comprise one or more source/drain patterns. A source/drain pattern may comprise one or more source/drain structures. The gate pattern may be disposed on the first conductivity-type doped pattern layer and between the source/drain structures of the source/drain pattern, and surrounding the channel pattern.

The source/drain pattern may include a first source/drain structure and a second source/drain structure spaced apart from each other.

The semiconductor device may further include a first upper contact electrode disposed on the first source/drain structure and connected to the first source/drain structure.

The lower contact electrode may be disposed under the second source/drain structure and connected to the second source/drain structure.

The semiconductor device may further include a second upper contact electrode disposed on the gate pattern and connected to the gate pattern.

The semiconductor device may further include a lower interconnection structure disposed under the lower pattern layer.

The semiconductor device may further include an upper interconnection structure disposed on a source/drain pattern, a gate pattern, or a combination thereof.

The semiconductor device may further include a lower insulating layer disposed under the lower pattern layer.

The lower contact electrode may be connected to the source/drain pattern by penetrating the lower insulating layer.

A semiconductor device according to another aspect includes a first conductivity-type doped pattern layer including a semiconductor material doped with a first conductivity-type impurity; a source/drain pattern disposed on the first conductivity-type doped pattern layer and including a semiconductor material doped with a second conductivity-type impurity different from the first conductivity-type impurity; a channel pattern including semiconductor patterns connected between the source/drain patterns and spaced apart from each other; a gate pattern disposed on the first conductivity-type doped pattern layer and between the source/drain patterns, and surrounding the channel pattern; and a lower contact electrode disposed under the source/drain pattern and connected to the source/drain pattern by penetrating the first conductivity-type doped pattern layer. The semiconductor device may comprise one or more source/drain patterns. A source/drain pattern may comprise one or more source/drain structures. The gate pattern may be disposed on the first conductivity-type doped pattern layer and between the source/drain structures of the source/drain pattern, and surrounding the channel pattern.

The source/drain pattern may include a first source/drain structure and a second source/drain structure spaced apart from each other.

The semiconductor device may further include a first upper contact electrode disposed on the first source/drain structure and connected to the first source/drain structure.

The lower contact electrode may be disposed under the second source/drain structure and connected to the second source/drain structure.

The semiconductor device may further include a lower insulating layer disposed under the first conductivity-type doped pattern layer.

The lower contact electrode may be connected to the source/drain pattern by penetrating the lower insulating layer.

According to the embodiments, since an etch can be formed deeply even in a device with a reduced size, the problem of unetching the source/drain can be solved, and current leakage from a lower portion of the source/drain can be prevented. When a backside power distribution network (BSPDN) structure is applied, a structure that removes all of the lower substrate (BSPDN Bulk-less) can also be easily implemented through the etching selectivity.

At least some of the above and other features of the invention are set out in the claims.

### BRIEF DESCRIPTION OF THE DRAWINGS

FIG. 1 is a plan view illustrating a semiconductor device according to an example embodiment.
FIG. 2A is a cross-sectional view taken along X-X' of FIG. 1, FIG. 2B is a cross-sectional view taken along Y-Y' of FIG. 1, and FIG. 2C is a cross-sectional view taken along Z-Z' of FIG. 1.
FIG. 3 is a cross-sectional view corresponding to the cross-sectional view taken along X-X' of FIG. 2 showing a semiconductor device according to another example embodiment.
FIGS. 4A and 4B are cross-sectional views corresponding to FIGS. 2A and 2B, respectively, illustrating semiconductor devices according to another example embodiment.
FIGS. 5A to 11B are cross-sectional views illustrating an intermediate step of a method of manufacturing a semiconductor device according to an example embodiment.
FIGS. 12A to 14B are cross-sectional views illustrating an intermediate step of a method of manufacturing a semiconductor device according to another example embodiment.
FIGS. 15 to 19 are cross-sectional views illustrating an intermediate step of a method of manufacturing a semiconductor device according to another example embodiment.
FIGS. 20A to 28B are cross-sectional views illustrating an intermediate step of a method of manufacturing a semiconductor device according to an example embodiment.
FIGS. 29A and 29B are cross-sectional views illustrating an intermediate step of a method of manufacturing a semiconductor device according to another example embodiment.

### DETAILED DESCRIPTION OF THE EMBODIMENTS

The present invention will be described more fully hereinafter with reference to the accompanying drawings, in which example embodiments are shown. As those skilled in the art would realize, the described embodiments may be modified in various different ways, all without departing from the scope of the present invention.

The drawings and description are to be regarded as illustrative in nature and not restrictive. Like reference numerals designate like elements throughout the specification.

The size and thickness of each constituent element as shown in the drawings are randomly indicated for better understanding and ease of description, and this disclosure is not necessarily limited to as shown. In the drawings, the thickness of layers, regions, etc., are exaggerated for clarity. In addition, in the drawings, for better understanding and ease of description, the thickness of some layers and areas is exaggerated.

It will be understood that when an element such as a layer, film, region, or substrate is referred to as being "connected" or "coupled" to or as "on" another element, it can be directly connected or coupled to or on the other element or intervening elements may also be present. In contrast, when an element is referred to as being "directly connected" or "directly coupled" or "directly on" another element, or as "contacting" or "in contact with" another element (or using any form of the word "contact"), there are no intervening elements present at the point of contact.

Spatially relative terms, such as "beneath," "below," "lower," "above," "upper" and the like, may be used herein for ease of description to describe one element's or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" the other elements or features. Thus, the term "below" can encompass both an orientation of above and below. The device may be otherwise oriented (rotated 90 degrees or at other orientations) and the spatially relative descriptors used herein interpreted accordingly.

Terms such as "same," "equal," "planar," or "coplanar," as used herein, encompass near identicality including variations that may occur, for example, due to manufacturing processes. The term "substantially" may be used herein to emphasize this meaning, unless the context or other statements indicate otherwise.

In addition, unless explicitly described to the contrary, the word "comprise," and variations such as "comprises" or "comprising," will be understood to imply the inclusion of stated elements but not the exclusion of any other elements.

In addition, in this specification, the phrase "on a plane" means viewing a target portion from the top, and the phrase "on a cross-section" means viewing a cross-section formed by vertically cutting a target portion from the side.

In the drawing of a semiconductor device according to an example embodiment, a transistor including nanowires or nanosheets, a multi-bridge channel field effect transistor (MBCFETTM), and a fin-type transistor including a fin-type pattern-shaped channel region (FinFET) are illustrated, but the present disclosure is not limited thereto. Of course, a semiconductor device according to some embodiments may include a tunneling transistor (tunneling FET), a 3D stack field effect transistor (3DSFET), or a complementary field effect transistor (CFET).

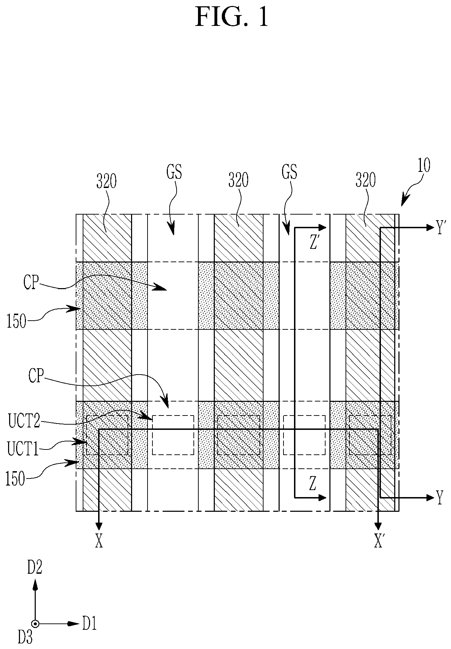

A semiconductor device according to an example embodiment will be described with reference to FIGS. 1 to 3.

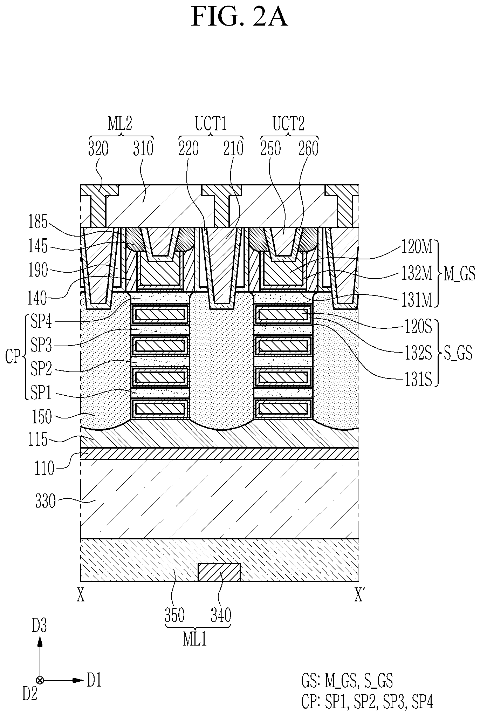

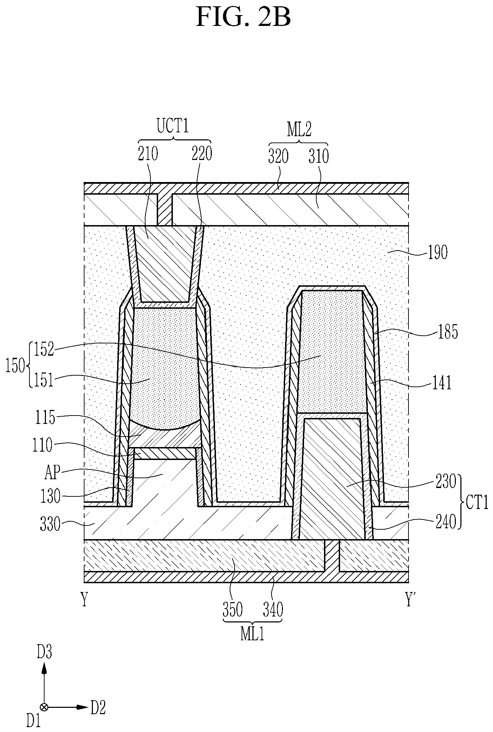

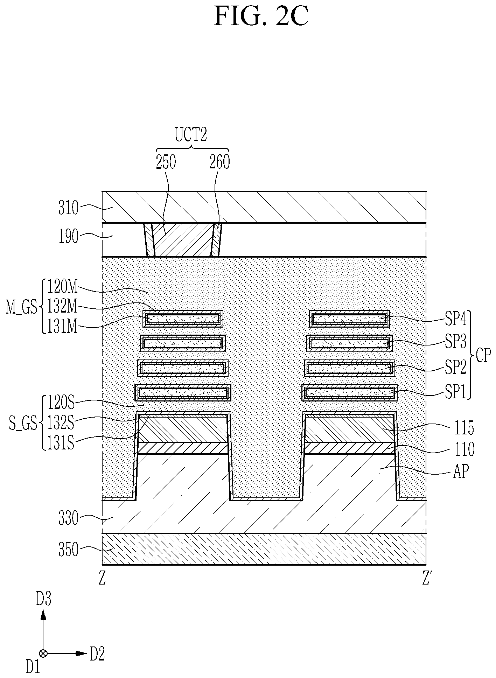

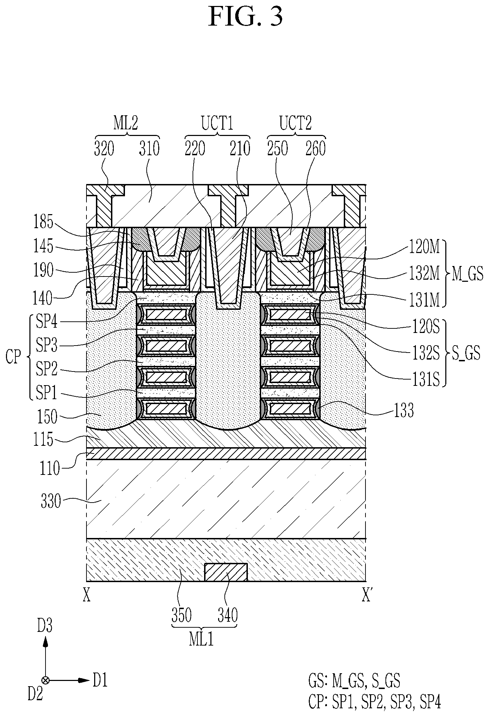

FIG. 1 is a plan view illustrating a semiconductor device according to an example embodiment. FIG. 2A is a cross-sectional view taken along X-X' of FIG. 1, FIG. 2B is a cross-sectional view taken along Y-Y' of FIG. 1, and FIG. 2C is a cross-sectional view taken along Z-Z' of FIG. 1. FIG. 3 is a cross-sectional view corresponding to the cross-sectional view taken along X-X' of FIG. 1 showing a semiconductor device according to another example embodiment.

Referring to FIGS. 1, 2A, 2B, and 2C, a semiconductor device 10 according to an embodiment includes a lower insulating layer 330, a lower pattern layer 110 disposed on the lower insulating layer 330, a first conductivity-type doped pattern layer 115 disposed on the lower pattern layer 110, one or more source/drain patterns 150 disposed on the first conductivity-type doped pattern layer 115, a channel pattern CP disposed between the source/drain patterns 150, and a gate pattern GS configured to cross between the source/drain patterns 150 and to surround the channel pattern CP. As will be described, the source/drain pattern 150 may comprise one or more source/drain structures 151 and 152. The gate pattern GS may be disposed on the first conductivity-type doped pattern layer 115 and between the source/drain structures 151 and 152 of the source/drain pattern 150, and surrounding the channel pattern CP.

A lower surface of the lower pattern layer 110 may contact an upper surface of the lower insulating layer 330, a lower surface of the first conductivity-type doped pattern layer 115 may contact an upper surface of the lower pattern layer 110, and a lower surface of the source/drain pattern 150 may contact an upper surface of the first conductivity-type doped pattern layer 115.

Optionally, the semiconductor device 10 may further include a first spacer 130 and a second spacer 141.

Optionally, the semiconductor device 10 may further include a gate spacer 140, a capping layer 145, an etch-stopping layer 185, and an interlayer insulating layer 190.

Optionally, the semiconductor device 10 may further include a lower contact electrode CT1 and a lower interconnection structure ML1.

Optionally, the semiconductor device 10 may further include a first upper contact electrode UCT1, a second upper contact electrode UCT2, and an upper interconnection structure ML2.

The lower insulating layer 330 may have an upper surface and a lower surface. The upper and lower surfaces of the lower insulating layer 330 may be formed as planes parallel to the first direction D1 and the second direction D2 crossing the first direction D1. The upper surface of the lower insulating layer 330 may be an opposite surface to the lower surface of the lower insulating layer 330 in the third direction D3. Herein, the third direction D3 may be a direction crossing the first direction D1 and the second direction D2. For example, the third direction D3 may be a thickness direction of the substrate 100. The lower surface of the lower insulating layer 330 may be referred to as a back side of the lower insulating layer 330. In some embodiments, a logic circuit of the cell region may be implemented on the upper surface of the lower insulating layer 330. Although the lower insulating layer 330 is shown as a single layer, it is only for convenience of explanation, and is not limited thereto. The first and second directions D1 and D2 may be coplanar. The first and second directions D1 and D2 may be perpendicular to each other. The third direction D3 may be perpendicular to both of the first and second directions D1 and D2.

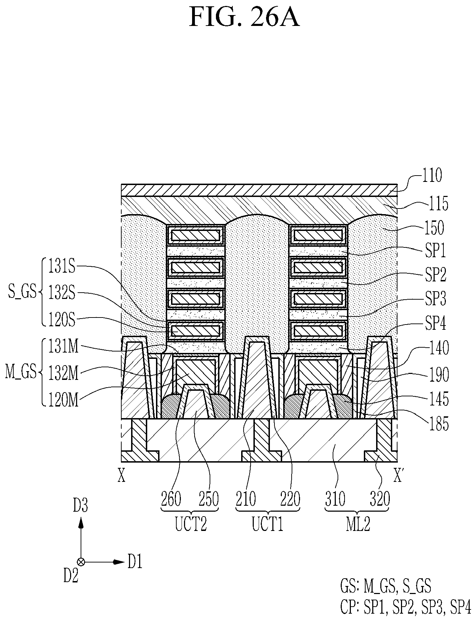

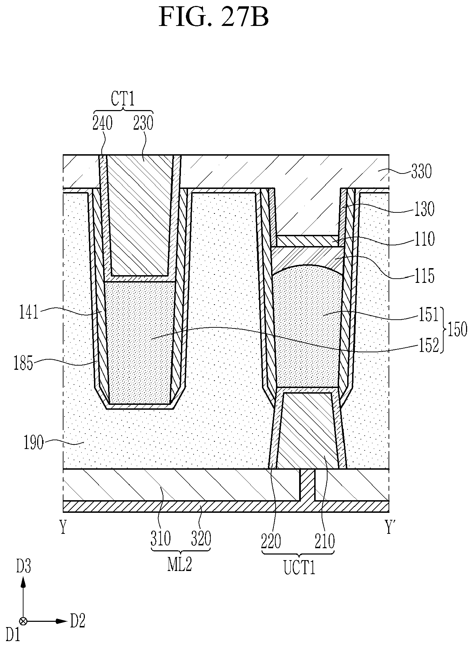

As illustrated in FIGS. 26A and 27B described later, the semiconductor device 10 according to an embodiment may be manufactured by removing the substrate 100 using the lower pattern layer 110 as an etch-stopping layer, and then by forming the lower insulating layer 330 in the place where the substrate 100 is present.

Accordingly, the lower insulating layer 330 may have a shape similar to that of the substrate 100, but may be made of a material different from that of the substrate 100. For example, the substrate 100 may include, for example, bulk silicon, silicon-on-insulator (SOI), silicon germanium (SiGe), silicon germanium on insulator (SGOI), indium antimonide, a lead tellurium compound, indium arsenide, indium phosphide, gallium arsenide, or gallium antimonide. The lower insulating layer 330 may include, for example, oxide, nitride, oxynitride, or a combination thereof.

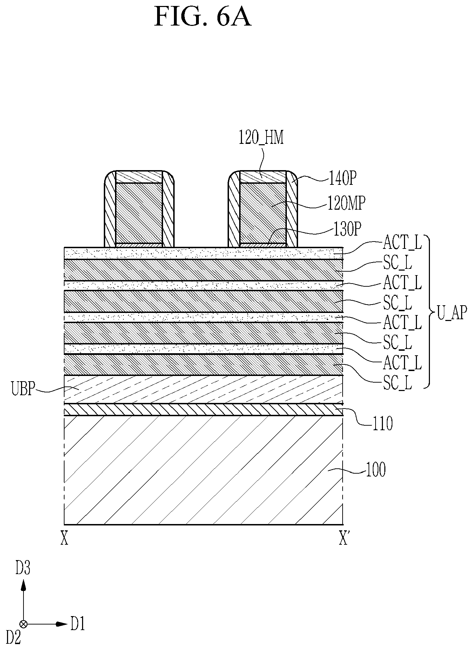

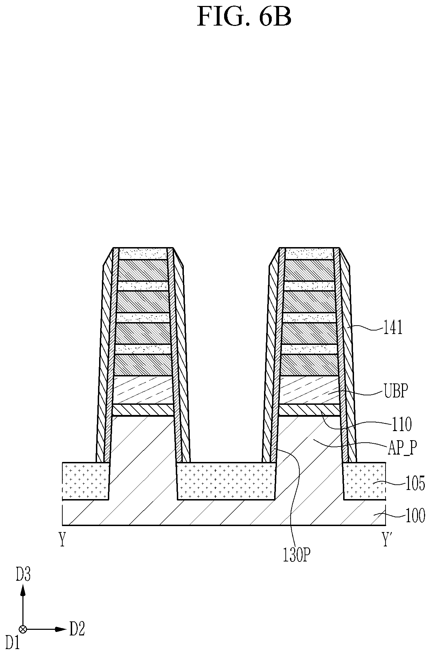

Also, as illustrated in FIGS. 6A and 6B described later, the substrate 100 has a trench defining the sacrificial active patterns AP_P, and a field insulating layer 105 may be disposed in the trench. In the process of removing the substrate 100, the field insulating layer 105 may be removed together. In this case, the lower insulating layer 330 may not include the field insulating layer 105. However, when, in the process of removing the substrate 100, the field insulating layer 105 is not removed together, the lower insulating layer 330 may include the field insulating layer 105.

Also, in the process of removing the substrate 100, even the sacrificial active patterns AP_P of the substrate 100 may be removed. The lower insulating layer 330 formed in the region where the substrate 100 is disposed has an active shape corresponding to a portion of the sacrificial active pattern AP_P, for example, an active pattern AP having a shape corresponding to the sacrificial active pattern AP_P protruding on the field insulating layer 105. The semiconductor device 10 may include a plurality of active patterns AP. Each of the active patterns AP may have a sheet or fin shape. The active patterns AP may extend lengthwise along a first direction D1 and may be spaced apart from each other along a second direction D2. For example, the active patterns AP may be disposed in an area where an NMOS is formed. As another example, the active patterns AP may be disposed in a region where a PMOS is formed.

Like the lower insulating layer 330, the active patterns AP may include, for example, an oxide, a nitride, an oxynitride, or a combination thereof.

The lower pattern layer 110 is disposed on the upper surface of the lower insulating layer 330.

The lower pattern layer 110 may extend lengthwise along the first direction D1 like the active patterns AP of the lower insulating layer 330 and may be spaced apart from each other along the second direction D2. The lower pattern layer 110 may contact upper surfaces of the active patterns AP.

The first spacer 130 may be disposed on both side surfaces of the lower pattern layer 110 and the active patterns AP in the second direction D2. The first spacer 130 may contact the side surfaces of the lower pattern layer 110 and the active patterns AP.

The lower pattern layer 110 may be overlapped with a source/drain pattern 150 to be described later in the third direction D3. The lower pattern layer 110 may extend in a first direction D1 crossing the gate pattern GS, which will be described later.

The lower pattern layer 110 may include a first semiconductor material having an etching selectivity with the substrate 100 or the semiconductor patterns SP1, SP2, SP3, and SP4 described later. For example, the first semiconductor material may include silicon (Si), germanium (Ge), or a combination thereof, and carbon (C). For example, the first semiconductor material may include about 0 at% to about 31.5 at% of the germanium (Ge), greater than about 0 at% and less than or equal to about 2 at% of the carbon (C), and a balance amount of the silicon (Si).

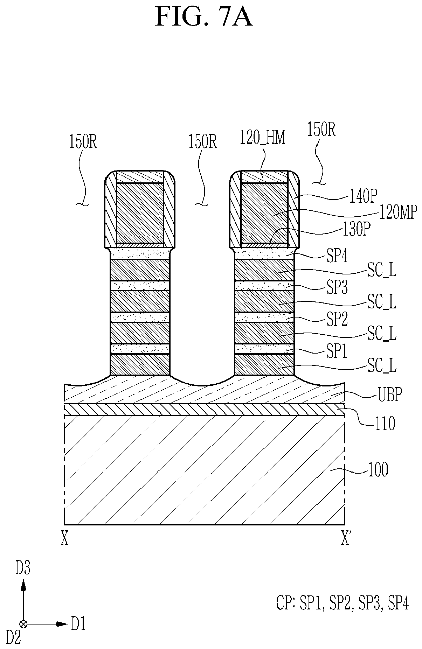

As shown in FIGS. 7A to 11B to be described later, when the source/drain recess 150R is formed and the sacrificial lower pattern UBP under the source/drain recess 150R is selectively removed, the lower pattern layer 110 may include a first semiconductor material having an etching selectivity with the substrate 100 or the semiconductor patterns SP1, SP2, SP3, and SP4, and thus the lower pattern layer 110 may act as an etch-stopping layer (wet stopper) to prevent the substrate 100 or the semiconductor patterns SP1, SP2, SP3, and SP4 from being etched.

The first conductivity-type doped pattern layer 115 may be disposed on the upper surface of the lower pattern layer 110.

The first conductivity-type doped pattern layer 115 may extend lengthwise along the first direction D1 like the lower pattern layer 110 and may be spaced apart from each other along the second direction D2.

The first conductivity-type doped pattern layer 115 may be overlapped with the source/drain pattern 150 to be described later in the third direction D3. The first conductivity-type doped pattern layer 115 may extend in a first direction D1 crossing the gate pattern GS, which will be described later.

The first conductivity-type doped pattern layer 115 may include a semiconductor material doped with a first conductivity-type impurity. Meanwhile, the source/drain pattern 150 to be described later may include a semiconductor material doped with impurities of a second conductivity-type impurity different from the first conductivity-type impurity. For example, the first conductivity-type doped pattern layer 115 may include a semiconductor material anti-doped with the source/drain pattern 150. The first conductivity-type doped pattern layer 115 can prevent current from leaking under the source/drain patterns 150, and accordingly, there is no need to secure a space for preventing leakage, so that the size of the semiconductor device 10 may be further reduced.

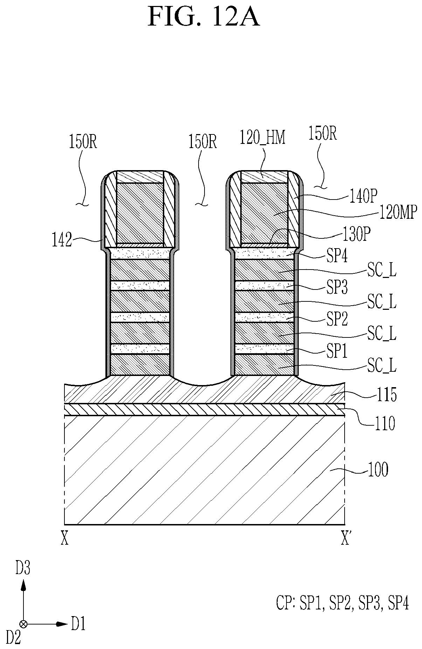

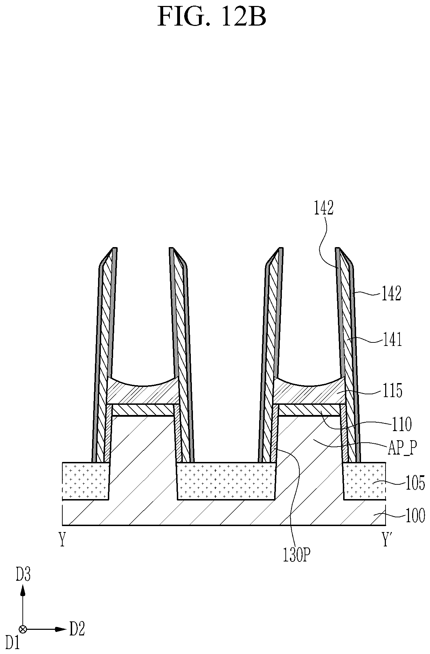

In addition, as shown in FIGS. 7A to 11B to be described later, after forming the source/drain recess 150R and selectively removing the sacrificial lower pattern UBP under the source/drain recess 150R, the first conductivity-type doped pattern layer 115 and the source/drain pattern 150 are formed together, or as shown in FIGS. 12A to 14B to be described later, after forming the first conductivity-type doped pattern layer 115, the source/drain pattern 150 may be formed. Current leaking under the source/drain patterns 150 may be prevented by the first conductivity-type doped pattern layer 115.

In addition, since the first conductivity-type doped pattern layer 115 is formed together with the source/drain pattern 150, the first conductivity-type doped pattern layer 115 does not hinder the growth of the source/drain pattern 150. Therefore, it is possible to prevent productivity decreases as the first conductivity-type doped pattern layer 115 inhibits the growth of the source/drain patterns 150, and to prevent performance deterioration due to stress effect reduction caused by defects in the source/drain pattern 150, dopant activation reduction, and diffusion increase due to crystal defects.

The first conductivity-type doped pattern layer 115 may include, for example, a semiconductor material such as at least one of silicon (Si) and silicon germanium (SiGe) doped with a first conductivity-type impurity.

For example, when the semiconductor material doped with the second conductivity-type impurity included in the source/drain pattern 150 includes the semiconductor material doped with an n-type impurity, that is, the source/drain pattern 150 is disposed in the NMOS region, the semiconductor material doped with the first conductivity-type impurity included in the first conductivity-type doped pattern layer 115 may include a semiconductor material doped with a p-type impurity. In addition, when the semiconductor material doped with the second conductivity-type impurity included in the source/drain pattern 150 includes a semiconductor material doped with a p-type impurity, that is, the source/drain pattern 150 is disposed in the PMOS region, the semiconductor material doped with the first conductivity-type impurity included in the first conductivity-type doped pattern layer 115 may include a semiconductor material doped with an n-type impurity.

For example, the n-type impurity may include phosphorus (P), arsenic (As), antimony (Sb), or a combination thereof. For example, when phosphorus (P) is used as an n-type impurity, a semiconductor material may be doped with phosphorus (P) through low-energy ion implantation, plasma ion implantation, or pulsed laser ablation deposition using phosphorus (P) or phosphine (PH₃) as an impurity gas.

The p-type impurity may include boron (B), aluminum (Al), gallium (Ga), indium (In), or a combination thereof. For example, when boron (B) is used as a p-type impurity, a semiconductor material may be doped with boron (B) through a low-energy ion implantation method, a plasma ion implantation method, or a pulsed laser ablation deposition method using boron (B), boron difluoride (BF₂), or boron trifluoride (BF₃) as an impurity gas.

As the first conductivity-type doped pattern layer 115 is formed together with the source/drain pattern 150, the first conductivity-type doped pattern layer 115 may be an epitaxial layer formed by a selective epitaxial growth process using the lower pattern layer 110 as a seed.

The second spacer 141 may be disposed on both side surfaces of the first spacer 130, the first conductivity-type doped pattern layer 115, and the source/drain pattern 150 in the second direction D2. For example, the second spacer 141 may contact the side surfaces of the first spacer 130, the first conductivity-type doped pattern layer 115, and the source/drain pattern 150. In this case, the second spacer 141 may cover the entire side surface of the source/drain pattern 150, but the present disclosure is not limited thereto, and the second spacer 141 may cover only a portion of the side surface of the source/drain pattern 150. For example, a height of the upper end of the second spacer 141 in the third direction D3 may be the same as a height of the upper end of the source/drain pattern 150 in the third direction D3, or may be lower than a height of the upper end of the source/drain pattern 150 in the third direction D3.

Meanwhile, in some embodiments, the second spacer 141 may not be disposed on both side surfaces of the source/drain pattern 150 in the second direction D2. In this case, the source/drain pattern 150 may also grow laterally in the second direction D2 during epitaxial growth, and thus may have a diamond shape with convex left and right sides.

The channel pattern CP may be disposed on an upper surface of the active pattern AP. The channel pattern CP may be spaced apart from the active pattern AP in the third direction D3.

The lower pattern layer 110 and the first conductivity-type doped pattern layer 115 may be disposed between the channel pattern CP and the active pattern AP. The channel pattern CP may also be spaced apart from the first conductivity-type doped pattern layer 115 in the third direction D3.

The channel pattern CP may include semiconductor patterns SP1, SP2, SP3, and SP4. For example, the channel pattern CP may include a first semiconductor pattern SP1, a second semiconductor pattern SP2, a third semiconductor pattern SP3, and a fourth semiconductor pattern SP4. The first semiconductor pattern SP1, the second semiconductor pattern SP2, the third semiconductor pattern SP3, and the fourth semiconductor pattern SP4 may be disposed higher than the upper surface of the first conductivity-type doped pattern layer 115.

The second semiconductor pattern SP2 may be disposed on the first semiconductor pattern SP1, the third semiconductor pattern SP3 may be disposed on the second semiconductor pattern SP2, and the fourth semiconductor pattern SP4 may be disposed on the third semiconductor pattern SP3. The second semiconductor pattern SP2 may be spaced apart from the first semiconductor pattern SP1 and the third semiconductor pattern SP3 in the third direction D3, and the third semiconductor pattern SP3 may be spaced apart from the second semiconductor pattern SP2 and the fourth semiconductor pattern SP4 in the third direction D3. Separation distances between the semiconductor patterns SP1, SP2, SP3, and SP4 may be substantially the same. However, the present disclosure is not limited thereto, and the separation distances between the semiconductor patterns SP1, SP2, SP3, and SP4 may be different.

The semiconductor patterns SP1, SP2, SP3, and SP4 may have substantially the same thickness, but are not limited thereto, and the thickness of at least one of the semiconductor patterns SP1, SP2, SP3, and SP4 may be different.

FIGS. 2A, 2B, and 2C, it is shown that four semiconductor patterns SP1, SP2, SP3, and SP4 are spaced apart from each other along the third direction D3, but this is for convenience of description, and the present disclosure is not limited thereto. For example, three or five or more semiconductor patterns may be spaced apart from each other along the third direction D3 and stacked.

The semiconductor patterns SP1, SP2, SP3, and SP4 may include a second semiconductor material different from the first semiconductor material included in the lower pattern layer 110.

In addition, each of the semiconductor patterns SP1, SP2, SP3, and SP4 may include the same semiconductor material as the sacrificial active pattern AP_P of the substrate 100 or a different semiconductor material from the sacrificial active pattern AP_P of the substrate 100.

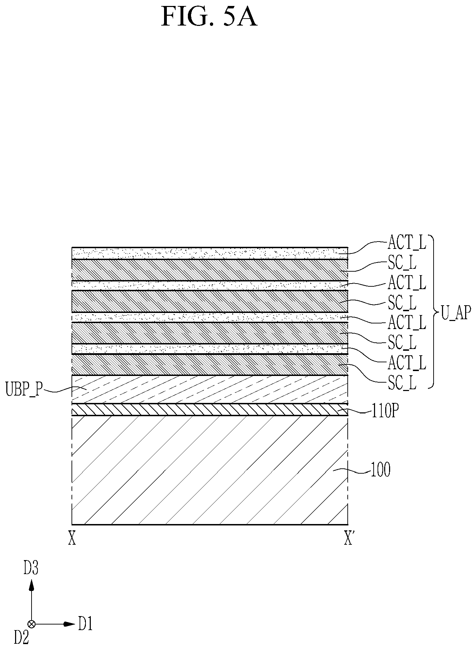

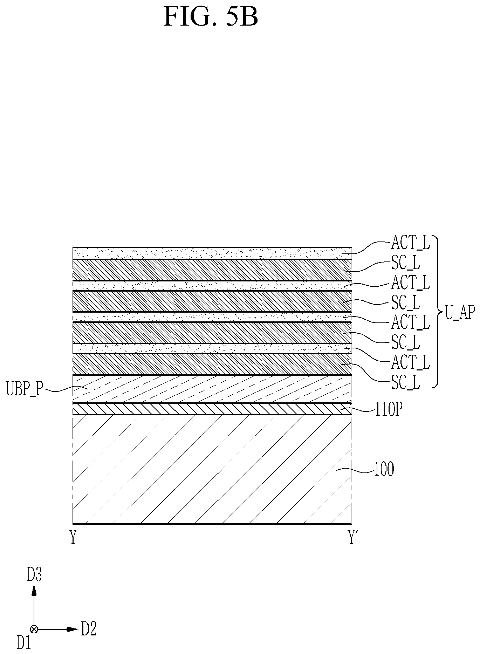

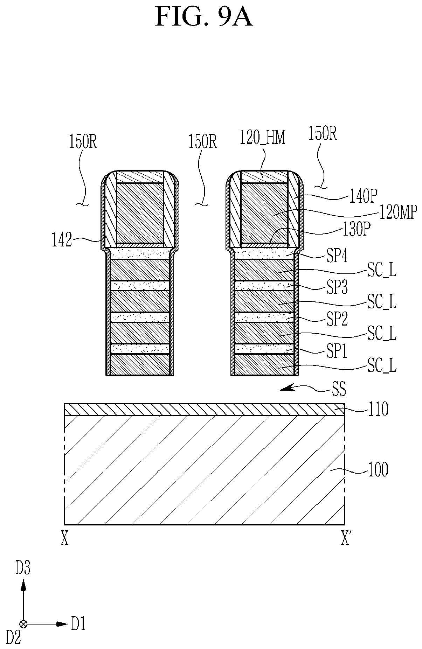

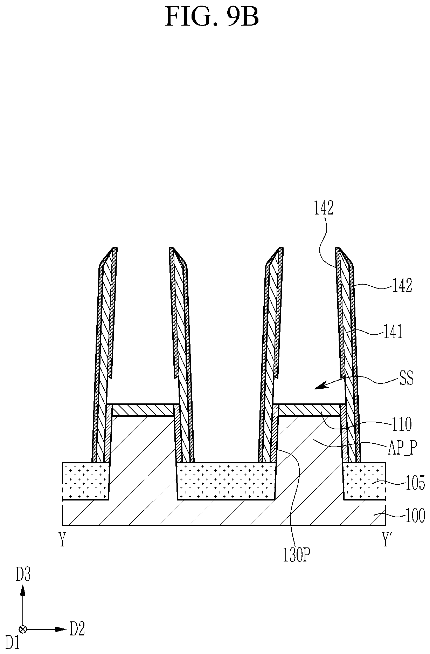

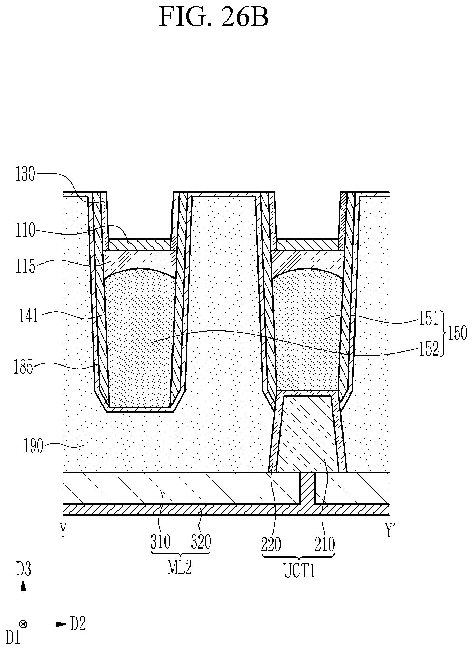

As the semiconductor patterns SP1, SP2, SP3, and SP4 include a second semiconductor material different from the first semiconductor material included in the lower pattern layer 110, as shown in FIGS. 5A and 5B to be described later, an upper pattern U_AP for forming the semiconductor patterns SP1, SP2, SP3, and SP4 may be easily formed. In addition, as shown in FIGS. 9A and 9B to be described later, when the sacrificial lower pattern UBP is removed, the lower pattern layer 110 acts as an etch-stopping layer (wet stopper) to prevent the substrate 100 or the semiconductor patterns SP1, SP2, SP3, and SP4 from being etched. In addition, as shown in FIGS. 26A and 26B described later, in the process of removing the entire substrate 100 when a backside power distribution network (BSPDN) structure is applied in the method of manufacturing the semiconductor device 10 according to an example embodiment, by using the lower pattern layer 110 as an etch-stopping layer (wet stopper), the BSPDN bulk-less structure (a structure in which all silicon substrates are removed) can be easily implemented through an etching selectivity.

For example, the second semiconductor material included in the semiconductor patterns SP1, SP2, SP3, and SP4 may include elemental semiconductor materials such as silicon (Si) or germanium (Ge). Also, the second semiconductor material may include a compound semiconductor, for example, a Group IV-IV compound semiconductor or a Group III-V compound semiconductor.

The Group IV-IV compound semiconductor may be, for example, a binary compound or ternary compound including at least two of carbon (C), silicon (Si), germanium (Ge), and tin (Sn).

The Group III-V compound semiconductor may be, for example, one of a binary compound, a ternary compound, or a quaternary compound formed by combining at least one of aluminum (Al), gallium (Ga), and indium (In) as a Group III element and one of phosphorus (P), arsenic (As), and antimony (Sb) as a Group V element.

The gate pattern GS may be disposed on the lower insulating layer 330. The lower pattern layer 110 and the first conductivity-type doped pattern layer 115 may be disposed between the gate pattern GS and the lower insulating layer 330.

The gate patterns GS may extend lengthwise in the second direction D2. The gate patterns GS may be spaced apart from each other in the first direction D1.

For example, each of the gate patterns GS may be disposed on the first conductivity-type doped pattern layer 115 and may cross the first conductivity-type doped pattern layer 115. A lower portion of the gate patterns GS may cross an upper portion of the first conductivity-type doped pattern layer 115.

The gate pattern GS may have sub-gate portions S_GS and a main gate portion M_GS. The sub-gate portions S_GS may be disposed between the adjacent semiconductor patterns SP1, SP2, SP3, and SP4 in the third direction D3 and between the first conductivity-type doped pattern layer 115 and the semiconductor patterns SP1, SP2, SP3, and SP4. The main gate portion M_GS may be disposed on the semiconductor patterns SP1, SP2, SP3, and SP4 at the uppermost portion in the third direction D3 and may be disposed between the semiconductor patterns SP1, SP2, SP3, and SP4 spaced apart from each other in the second direction D2.

As the channel pattern CP includes a plurality of semiconductor patterns SP1, SP2, SP3, and SP4, the gate pattern GS may include a plurality of sub-gate portions S_GS. The number of sub-gate portions S_GS may be proportional to the number of the semiconductor patterns SP1, SP2, SP3, and SP4 included in the channel pattern CP. For example, the number of sub-gate portions S_GS may be the same as the number of the semiconductor patterns SP1, SP2, SP3, and SP4.

The sub-gate portions S_GS may include a first sub-gate portion, a second sub-gate portion, a third sub-gate portion, and a fourth sub-gate portion. The first sub-gate portion, the second sub-gate portion, the third sub-gate portion, and the fourth sub-gate portion may be sequentially spaced apart and stacked on the lower insulating layer 330 in the third direction D3. In the following description, a case in which the number of sub-gate portions S_GS is four will be described. However, the present disclosure is not limited thereto, and may include 3 or 5 or more sub-gate portions.

For example, the first sub-gate portion may be disposed between the upper surface of the first conductivity-type doped pattern layer 115 and the lower surface of the first semiconductor pattern SP1; the second sub-gate portion may be disposed between the upper surface of the first semiconductor pattern SP1 and the lower surface of the second semiconductor pattern SP2; the third sub-gate portion may be disposed between the upper surface of the second semiconductor pattern SP2 and the lower surface of the third semiconductor pattern SP3; and the fourth sub-gate portion may be disposed between the upper surface of the third semiconductor pattern SP3 and the lower surface of the fourth semiconductor pattern SP4.

The sub-gate portions S_GS may be spaced apart from each other in the first direction D1 between source/drain patterns 150 to be described later.

Each of the sub-gate portions S_GS may include a sub-gate electrode 120S, a sub-interface insulating layer 131S, and a sub-gate insulating layer 132S.

The sub-gate electrode 120S may be disposed on the first conductivity-type doped pattern layer 115. The sub-gate electrode 120S may cross the active pattern AP.

At least a portion of the sub-gate electrode 120S may be disposed on the stacked structure of the sub-gate electrode 120S and the channel pattern CP. In this case, a portion of the main gate electrode 120M may be disposed to cover both side surfaces of the stacked structure of the sub-gate electrode 120S and the channel pattern CP. Accordingly, four surfaces of the channel pattern CP may be surrounded by the sub-gate electrode 120S and the main gate electrode 120M.

The sub-gate electrode 120S may include a metal, a metal alloy, a conductive metal nitride, a metal silicide, a doped semiconductor material, a conductive metal oxide, or a conductive metal oxynitride. The sub-gate electrode 120S may include, for example, titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAIN), tantalum aluminum nitride (TaAIN), tungsten nitride (WN), ruthenium (Ru), titanium aluminum (TiAl), titanium aluminum carbonitride (TiAIC-N), titanium aluminum carbide (TiAIC), titanium carbide (TiC), tantalum carbonitride (TaCN), tungsten (W), aluminum (Al), copper (Cu), cobalt (Co), titanium (Ti), tantalum (Ta), nickel (Ni), platinum (Pt), nickel-platinum (Ni-Pt), niobium (Nb), niobium nitride (NbN), niobium carbide (NbC), molybdenum (Mo), molybdenum nitride (MoN), molybdenum carbide (MoC), tungsten carbide (WC), rhodium (Rh), palladium (Pd), iridium (Ir), osmium (Os), silver (Ag), gold (Au), zinc (Zn), vanadium (V), or a combination thereof, but is not limited thereto. The conductive metal oxide and the conductive metal nitroxide may include an oxidized form of the above material, but are not limited thereto.

The sub-interface insulating layer 131S may be disposed on an upper surface of the first conductivity-type doped pattern layer 115. The sub-interface insulating layer 131S may be disposed along the circumference of the channel pattern CP. The sub-interface insulating layer 131S may directly contact the first conductivity-type doped pattern layer 115, the source/drain pattern 150, and the channel pattern CP. The sub-interface insulating layer 131S may be disposed between the channel pattern CP and the sub-gate insulating layer 132S.

The sub-gate insulating layer 132S may be disposed on an upper surface of the sub-interface insulating layer 131S. The sub-gate insulating layer 132S may surround the channel pattern CP. The sub-gate insulating layer 132S may be disposed along the circumference of the channel pattern CP. The sub-gate insulating layer 132S may be disposed between the sub-gate electrode 120S and the sub-interface insulating layer 131S.

As illustrated in FIG. 3 described later, the sub-gate insulating layer 132S may be disposed between the sub-gate electrode 120S and the inner gate spacer 133.

The sub-interface insulating layer 131S may include, for example, silicon oxide (SiO₂). The sub-gate insulating layer 132S may include, for example, a high dielectric constant material. The high dielectric constant material may include a material having a higher dielectric constant than silicon oxide (SiO₂), such as hafnium oxide (HfO), aluminum oxide (AIO), or tantalum oxide (TaO).

The main gate portion M_GS may be disposed on the uppermost fourth semiconductor pattern SP4 in a region intersecting the active pattern AP, and may be disposed on the lower insulating layer 330 in a region not intersecting the active pattern AP.

Accordingly, the gate pattern GS may surround the channel pattern CP. For example, surfaces of the semiconductor patterns SP1, SP2, SP3, and SP4 that are not connected to the source/drain pattern 150, for example, four surfaces, may be surrounded by the gate pattern GS. That is, the sub-gate portions S_GS may surround the upper and lower portions of the semiconductor patterns SP1, SP2, SP3, and SP4, and the main gate portion M_GS may surround side surfaces of the semiconductor patterns SP1, SP2, SP3, and SP4 and an upper portion of the uppermost semiconductor pattern SP4.

The main gate portion M_GS may include a main gate electrode 120M, an interface insulating layer 131M, and a gate insulating layer 132M.

The main gate electrode 120M may include a metal, a metal alloy, a conductive metal nitride, a metal silicide, a doped semiconductor material, a conductive metal oxide, a conductive metal nitride, or a combination thereof. For example, the main gate electrode 120M may include titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAIN), tantalum aluminum nitride (TaAIN), tungsten nitride (WN), ruthenium (Ru), titanium aluminum (TiAl), titanium aluminum carbonitride (TiAIC-N), titanium aluminum carbide (TiAIC), titanium carbide (TiC), tantalum carbonitride (TaCN), tungsten (W), aluminum (Al), copper (Cu), cobalt (Co), titanium (Ti), tantalum (Ta), nickel (Ni), platinum (Pt), nickel-platinum (Ni-Pt), niobium (Nb), niobium nitride (NbN), niobium carbide (NbC), molybdenum (Mo), molybdenum nitride (MoN), molybdenum carbide (MoC), tungsten carbide (WC), rhodium (Rh), palladium (Pd), iridium (Ir), osmium (Os), silver (Ag), gold (Au), zinc (Zn), vanadium (V), or a combination thereof, but is not limited thereto. The conductive metal oxide and the conductive metal nitroxide may include an oxidized form of the above material, but are not limited thereto.

The interface insulating layer 131M may extend along upper surfaces of the semiconductor patterns SP1, SP2, SP3, and SP4 and the upper surface of the active pattern AP. The interface insulating layer 131M may not extend along the side surface of the gate spacer 140 to be described later. However, the present disclosure is not limited thereto, and the interface insulating layer 131M may extend along the side surface of the gate spacer 140.

The interface insulating layer 131M may include, for example, silicon oxide (SiO₂). The gate insulating layer 132M may include, for example, a high dielectric constant material. The high dielectric constant material may include a material having a higher dielectric constant than silicon oxide (SiO₂), such as hafnium oxide (HfO), aluminum oxide (AIO), or tantalum oxide (TaO).

The gate insulating layer 132M may extend along the side surfaces and lower surfaces of the main gate electrode 120M. The gate insulating layer 132M may extend along the side surfaces of the gate spacer 140.

The gate insulating layer 132M may include, for example, a high dielectric constant material. The high dielectric constant material may include a material having a higher dielectric constant than silicon oxide (SiO₂), such as hafnium oxide (HfO), aluminum oxide (AlO), or tantalum oxide (TaO).

The gate spacer 140 may be disposed on a side surface of the main gate electrode 120M. The gate spacer 140 may contact the side surface of the gate insulating layer 132M of the main gate electrode 120M. The gate spacer 140 is not disposed between the active pattern AP and the semiconductor patterns SP1, SP2, SP3, and SP4. The gate spacer 140 is not disposed between the semiconductor patterns SP1, SP2, SP3, and SP4 adjacent in the third direction D3.

The gate spacer 140 may include, for example, silicon nitride (SiN), silicon oxynitride (SiON), silicon oxide (SiO₂), silicon oxycarbonitride (SiOCN), silicon boron nitride (SiBN), silicon oxyboronitride (SiOBN), silicon oxycarbide (SiOC), or a combination thereof. Although the gate spacer 140 is illustrated as being a single layer, it is only for convenience of description and is not limited thereto.

Meanwhile, as shown in FIG. 3, the inner gate spacer 133 may be disposed between the sub-gate portions S_GS and the source/drain pattern 150.

The inner gate spacer 133 may contact the sub-gate structures S_GS and the source/drain pattern 150, respectively. The inner gate spacer 133 may be disposed between the first conductivity-type doped pattern layer 115 and the channel pattern CP and between the channel patterns CP adjacent to each other in the third direction D3.

The inner gate spacer 133 may include a low dielectric constant material. The low dielectric constant material may include silicon oxide or a material having a lower dielectric constant than silicon oxide. For example, the low dielectric constant material may include silicon oxide, silicon oxide doped with fluorine or carbon, porous silicon oxide, or an organic polymeric dielectric. For another example, the inner gate spacer 133 may include silicon nitride (SiN), silicon oxynitride (SiON), silicon carbonitride (SiCN), or silicon oxycarbonitride (SiOCN).

Referring back to FIGS. 1, 2A, 2B, and 2C, the capping layer 145 may be disposed on the main gate portion M_GS and the gate spacer 140. For example, the capping layer 145 may contact upper surfaces of the main gate electrode 120M and the gate insulating layer 132M of the main gate portion M_GS and an upper surface of the gate spacer 140. An upper surface of the capping layer 145 and an upper surface of the interlayer insulating layer 190 may be on the same plane. Unlike that shown, the capping layer 145 may be disposed between the gate spacers 140.

The capping layer 145 may include, for example, silicon nitride (SiN), silicon nitride (SiON), silicon carbonitride (SiCN), silicon oxycarbonitride (SiOCN), or a combination thereof. The capping layer 145 may include a material having an etching selectivity with respect to the interlayer insulating layer 190.

The source/drain pattern 150 may be disposed on the active pattern AP.

The source/drain pattern 150 may be disposed in the source/drain recess 150R extending in the third direction D3. The source/drain recess 150R may be formed as shown in FIGS. 7A to 11B described later. The source/drain pattern 150 may fill the source/drain recess 150R. A bottom surface of the source/drain recess 150R may be defined by the first conductivity-type doped pattern layer 115. Side surfaces of the source/drain recess 150R may be defined by the semiconductor patterns SP1, SP2, SP3, and SP4 and sub-gate portions S_GS. The bottom surface of the source/drain pattern 150 may contact the first conductivity-type doped pattern layer 115. The side surfaces of the source/drain pattern 150 may contact the semiconductor patterns SP1, SP2, SP3, and SP4.

The source/drain pattern 150 may be disposed on side surfaces of the sub-gate portions S_GS. For example, the source/drain patterns 150 may contact side surfaces of the sub-interface insulating layer 131S or the inner gate spacer 133 of the sub-gate portions S_GS. The source/drain pattern 150 may be disposed between adjacent sub-gate portions S_GS in the first direction D1. For example, the source/drain patterns 150 may be disposed on both sides of the sub-gate portions S_GS.

The source/drain pattern 150 may be disposed on side surfaces of the semiconductor patterns SP1, SP2, SP3, and SP4 of the channel pattern CP. For example, the source/drain pattern 150 may contact side surfaces of the semiconductor patterns SP1, SP2, SP3, and SP4. The source/drain pattern 150 may be disposed between semiconductor patterns SP1, SP2, SP3, and SP4 adjacent to each other in the first direction D1.

In example embodiments, a side surface of the source/drain pattern 150 may have an uneven wavy shape. For example, side surfaces of the source/drain pattern 150 adjacent to the sub-gate portions S_GS may have a concave shape toward the sub-gate portions S_GS, and a side surface of the source/drain pattern 150 adjacent to the semiconductor patterns SP1, SP2, SP3, and SP4 may have a convex shape toward the semiconductor patterns SP1, SP2, SP3, and SP4.

The source/drain patterns 150 may be epitaxial patterns formed by a selective epitaxial growth process. The source/drain pattern 150 may include, for example, at least one of silicon (Si) and silicon germanium (SiGe). The source/drain pattern 150 may serve as a source/drain of a transistor using the semiconductor patterns SP1, SP2, SP3, and SP4 as a channel region.

As described above, the source/drain pattern 150 may include a semiconductor material doped with a second conductivity-type impurity different from the semiconductor material doped with the first conductivity-type impurity included in the first conductivity-type doped pattern layer 115.

The source/drain pattern 150 may include, for example, a semiconductor material such as at least one of silicon (Si) and silicon germanium (SiGe) doped with a second conductivity-type impurity.

For example, when the semiconductor material doped with the second conductivity-type impurity included in the source/drain pattern 150 includes a semiconductor material doped with an n-type impurity, that is, the source/drain pattern 150 is disposed in the NMOS region, the semiconductor material doped with the first conductivity-type impurity included in the first conductivity-type doped pattern layer 115 may include a semiconductor material doped with a p-type impurity. In addition, when the semiconductor material doped with the second conductivity-type impurity included in the source/drain pattern 150 includes a semiconductor material doped with a p-type impurity, that is, the source/drain pattern 150 is disposed in the PMOS region, the semiconductor material doped with the first conductivity-type impurity included in the first conductivity-type doped pattern layer 115 may include a semiconductor material doped with an n-type impurity.

For example, the n-type impurity may include phosphorus (P), arsenic (As), antimony (Sb), or a combination thereof. For example, when phosphorus (P) is used as an n-type impurity, a semiconductor material may be doped with phosphorus (P) through low-energy ion implantation, plasma ion implantation, or pulsed laser ablation deposition using phosphorus (P) or phosphine (PH₃) as an impurity gas.

The p-type impurity may include boron (B), aluminum (Al), gallium (Ga), indium (In), or a combination thereof. For example, when boron (B) is used as a p-type impurity, a semiconductor material may be doped with boron (B) through low-energy ion implantation, plasma ion implantation, or pulsed laser ablation deposition using boron (B), boron difluoride (BF₂), or boron trifluoride (BF₃) as an impurity gas.

The source/drain pattern 150 may include a first source/drain structure 151 and a second source/drain structure 152.

The first source/drain structure 151 and the second source/drain structure 152 may be connected to a first upper contact electrode UCT1 or a lower contact electrode CT1 to be described later. For example, the first source/drain structure 151 may be connected to the first upper contact electrode UCT1 and the second source/drain structure 152 may be connected to the lower contact electrode CT1. Hereinafter, the source/drain pattern 150 connected to the first upper contact electrode UCT1 is referred to as the first source/drain structure 151 and the source/drain pattern 150 connected to the lower contact electrode CT1 is referred to as a second source/drain structure 152.

The first source/drain structure 151 and the second source/drain structure 152 may be spaced apart from each other in the second direction D2 along the extending direction of the gate pattern GS. An interlayer insulating layer 190 to be described later may be disposed between the first source/drain structure 151 and the second source/drain structure 152.

The etch-stopping layer 185 may be disposed on a side surface of the gate spacer 140 and an upper surface of the source/drain pattern 150. The etch-stopping layer 185 may contact the side surface of the gate spacer 140 and the upper surface of the source/drain pattern 150. The etch-stopping layer 185 may include a material having an etching selectivity with respect to the interlayer insulating layer 190 to be described later. The etch-stopping layer 185 may include, for example, silicon nitride (SiN), silicon oxynitride (SiON), silicon oxycarbonitride (SiOCN), silicon boron nitride (SiBN), silicon oxyboronitride (SiOBN), silicon oxycarbide (SiOC), or a combination thereof.

The interlayer insulating layer 190 may be disposed on the etch-stopping layer 185. The interlayer insulating layer 190 may contact the etch-stopping layer 185. An interlayer insulating layer 190 may be disposed on the source/drain pattern 150. The interlayer insulating layer 190 may not cover the upper surface of the capping layer 145.

The interlayer insulating layer 190 may include, for example, at least one of silicon oxide (SiO₂), silicon nitride (SiN), silicon nitride (SiON), or a low dielectric constant material. The low dielectric constant material may include, for example, fluorinated tetraethylorthosilicate (FTEOS), hydrogen silses quioxane (HSQ), bis-benzocyclobutene (BCB), tetramethylorthosilicate (TMOS), octamethylcyclotetrasiloxane (OMCTS), hexamethyldisiloxane (HMDS), trimethylsilyl borate (TMSB), diacetoxyditertiarybutosiloxane (DADBS), trimethylsilyl Phosphate (TMSP), polytetrafluoroethylene (PTFE), TOSZ (tonen SilaZen), FSG (fluoride silicate glass), polyimide nanofoams such as polypropylene oxide, CDO (carbon doped silicon oxide), OSG (organo silicate glass), SiLK, amorphous fluorinated carbon, silica aerogels, silica xerogels, mesoporous silica, or a combination thereof, but is not limited thereto.

A lower interconnection structure ML1 may be disposed under the lower surface of the lower insulating layer 330. The lower interconnection structure ML1 may contact the lower surface of the lower insulating layer 330. The lower interconnection structure ML1 may be, for example, a power delivery network that supplies voltage (e.g., power supply voltage, etc.) to the source/drain pattern 150.

The lower interconnection structure ML1 may include lower interconnections 340 and a lower interconnection insulating layer 350.

The lower interconnections 340 may be disposed on a lower surface of the lower insulating layer 330. The lower interconnections 340 may include metal (e.g., copper). The lower interconnections 340 may be electrically connected to the lower contact electrode CT1. Descriptions thereof will be given later.

The lower interconnection insulating layer 350 may contact upper and side surfaces of the lower interconnections 340. Lower surfaces of the lower interconnections 340 and the lower interconnection insulating layer 350 may be coplanar.

In addition, in FIGS. 1, 2A, 2B, and 2C, the lower interconnections 340 extend lengthwise in the second direction D2 parallel to the direction in which the gate pattern GS extends, but are not limited thereto. For example, the lower interconnections 340 may extend in a first direction D1 crossing the direction in which the gate pattern GS extends.

The lower interconnection insulating layer 350 may be disposed under the lower surface of the lower insulating layer 330. The lower interconnection insulating layer 350 may cover the lower interconnections 340, and the lower interconnections 340 may be disposed within the lower interconnection insulating layer 350. The lower interconnection insulating layer 350 may include, for example, at least one of silicon oxide (SiO₂), silicon nitride (SiN), silicon oxynitride (SiON), or low-k dielectric layers.

The lower contact electrode CT1 may be disposed between the source/drain pattern 150 and the lower interconnection structure ML1.

The lower contact electrode CT1 may be connected to at least one source/drain pattern 150. For example, the lower contact electrode CT1 may be connected to the second source/drain structure 152. The lower contact electrode CT1 may contact the second source/drain structure 152. The lower contact electrode CT1 may not be connected to the first source/drain structure 151.

In the following description, a case in which the lower contact electrode CT1 is connected to the second source/drain structure 152 and not connected to the first source/drain structure 151 will be described. In this case, the first source/drain structure 151 may be connected to the first upper contact electrode UCT1, and the second source/drain structure 152 may not be connected to the first upper contact electrode UCT1. However, the present disclosure is not limited thereto, and the lower contact electrode CT1 may be connected to the first source/drain structure 151. The lower contact electrode CT1 may not be connected to the second source/drain structure 152. In this case, the second source/drain structure 152 may be connected to the first upper contact electrode UCT1, and the first source/drain structure 151 may not be connected to the first upper contact electrode UCT1.

The lower contact electrode CT1 may be disposed between the second source/drain structure 152 and the lower interconnection structure ML1. The lower contact electrode CT1 may extend from the second source/drain structure 152 to the lower interconnection structure ML1 in the third direction D3. A lower surface of the lower contact electrode CT1 may be connected to the lower interconnection structure ML1. An upper surface of the lower contact electrode CT1 may be connected to the second source/drain structure 152. The lower contact electrode CT1 may penetrate the lower pattern layer 110 and the first conductivity-type doped pattern layer 115.

In addition, the lower contact electrode CT1 may be disposed within the lower insulating layer 330, and the lower contact electrode CT1 penetrates the lower insulating layer 330 so that an upper surface of the lower contact electrode CT1 may be connected to the second source/drain structure 152 and a lower surface of the lower contact electrode CT1 may be connected to the lower interconnection structure ML1. In example embodiments, a lower surface of the lower contact electrode CT1 may be coplanar with a lower surface of the lower insulating layer 330.

The second source/drain structure 152 and the lower interconnection structure ML1 may be electrically connected to each other through the lower contact electrode CT1. That is, a voltage (e.g., a power voltage, etc.) may be applied from the lower interconnection structure ML1 to the second source/drain structure 152 through the lower contact electrode CT1.

The lower contact electrode CT1 may include a conductive pattern 230 and a barrier pattern 240 configured to surround the conductive pattern 230.

The conductive pattern 230 may include, for example, at least one of a metal, a metal alloy, a conductive metal nitride, a conductive metal carbide, a conductive metal oxide, a conductive metal carbonitride, and a two-dimensional (2D) material.

The barrier pattern 240 may cover sidewalls and an upper surface of the conductive pattern 230. For example, the barrier pattern 240 may contact upper and side surfaces of the conductive pattern 230. The barrier pattern 240 may include a metal, a metal alloy, or a conductive metal nitride. The metal may include at least one of titanium (Ti), tantalum (Ta), tungsten (W), nickel (Ni), cobalt (Co), and platinum (Pt). The conductive metal nitride may include at least one of titanium nitride (TiN), tantalum nitride (TaN), tungsten nitride (WN), nickel nitride (NiN), cobalt nitride (CoN), and platinum nitride (PtN).

Although the lower contact electrode CT1 is illustrated as being a double layer including the conductive pattern 230 and the barrier pattern 240, it is only for convenience of explanation, but the present disclosure is not limited thereto.

Although not shown in the drawing, a metal silicide layer may be further disposed between the second source/drain structure 152 and the lower contact electrode CT1 of the semiconductor device 10 according to some embodiments. For example, the metal silicide layer may be disposed along the interface of the lower contact electrode CT1 contacting the second source/drain structure 152. The metal silicide layer may include metal silicide.

The upper interconnection structure ML2 may be disposed on an upper surface of the interlayer insulating layer 190. The upper interconnection structure ML2 may be, for example, a power delivery network that supplies a voltage (e.g., a power supply voltage, etc.) to the gate pattern GS or the source/drain pattern 150.

The upper interconnection structure ML2 may include upper interconnections 320 and an upper interconnection insulating layer 310.

The upper interconnections 320 may be disposed on an upper surface of the interlayer insulating layer 190. The upper interconnections 320 may include metal (e.g., copper). The upper interconnections 320 may be electrically connected to first or second upper contact electrodes UCT1 and UCT2 described later. FIGS. 1, 2A, 2B, and 2C show that the upper interconnections 320 are connected to a first upper contact electrode UCT1 described later and not connected to a second upper contact electrode UCT2 described later. However, the present disclosure is not limited thereto. For example, the upper interconnections 320 may be connected to the second upper contact electrode UCT2 and may not be connected to the first upper contact electrode UCT1. Alternatively, the upper interconnections 320 may be connected to the first upper contact electrode UCT1 and the second upper contact electrode UCT2, respectively.

In addition, in FIGS. 1, 2A, 2B, and 2C, the upper interconnections 320 extend in the second direction D2 parallel to the direction in which the gate pattern GS extends, but the present disclosure is not limited thereto.. For example, the upper interconnections 320 may extend in a first direction D1 crossing the direction in which the gate pattern GS extends.

The upper interconnection insulating layer 310 may be disposed on an upper surface of the interlayer insulating layer 190. The upper interconnection insulating layer 310 may contact the upper surface of the interlayer insulating layer 190. The upper interconnection insulating layer 310 may cover the upper interconnection structure ML2. For example, the upper interconnection insulating layer 310 may cover the upper interconnections 320, and the upper interconnections 320 may be disposed within the upper interconnection insulating layer 310. The upper interconnection insulating layer 310 may contact lower and side surfaces of the upper interconnections 320. The upper interconnection insulating layer 310 may include, for example, at least one of silicon oxide (SiO₂), silicon nitride (SiN), silicon oxynitride (SiON), or low-k dielectric layers.

The first upper contact electrode UCT1 may be disposed between the source/drain pattern 150 and the upper interconnection structure ML2.

The first upper contact electrode UCT1 may be connected to at least one source/drain pattern 150. For example, the first upper contact electrode UCT1 may be connected to the first source/drain structure 151. The first upper contact electrode UCT1 may not be connected to the second source/drain structure 152. In the following description, a case in which the first upper contact electrode UCT1 is connected to the first source/drain structure 151 and not connected to the second source/drain structure 152 will be described.

The first upper contact electrode UCT1 may be disposed on one side of the main gate structure M_GS. The first upper contact electrode UCT1 may be disposed on the source/drain pattern 150. For example, the first upper contact electrode UCT1 may be disposed on the first source/drain structure 151. The first upper contact electrode UCT1 may not be disposed on the second source/drain structure 152.

The first upper contact electrode UCT1 may penetrate at least one interlayer insulating layer 190. For example, the first upper contact electrode UCT1 may penetrate the interlayer insulating layer 190 on the first source/drain structure 151 and be connected to the first source/drain structure 151. The first upper contact electrode UCT1 may contact the first source/drain structure 151. The first upper contact electrode UCT1 may not penetrate the interlayer insulating layer 190 on the second source/drain structure 152. That is, the first upper contact electrode UCT1 may not be connected to the second source/drain structure 152.

A lower surface of the first upper contact electrode UCT1 may be disposed at a level similar to that of, for example, an upper surface of the fourth semiconductor pattern SP4 disposed at the uppermost portion of the channel pattern CP. However, the present disclosure is not limited thereto, and the lower surface of the first upper contact electrode UCT1 may be higher or lower than the lower surface of the fourth semiconductor pattern SP4 disposed at the uppermost portion of the channel pattern CP. Alternatively, the lower surface of the first upper contact electrode UCT1 may be disposed between the lower surface of the first semiconductor pattern SP1 disposed at the lowermost portion of the channel pattern CP and the lower surface of the fourth semiconductor pattern SP4 disposed at the uppermost portion.

The first upper contact electrode UCT1 may include a conductive pattern 210 and a barrier pattern 220 configured to surround the conductive pattern 210.

The conductive pattern 210 may include, for example, at least one of a metal, a metal alloy, a conductive metal nitride, a conductive metal carbide, a conductive metal oxide, a conductive metal carbonitride, and a two-dimensional (2D) material.

The barrier pattern 220 may cover sidewalls and a lower surface of the conductive pattern 210. The barrier pattern 220 may contact the sidewalls and the lower surface of the conductive pattern 210. The barrier pattern 220 may include a metal, a metal alloy, or a conductive metal nitride. The metal may include at least one of titanium (Ti), tantalum (Ta), tungsten (W), nickel (Ni), cobalt (Co), and platinum (Pt). The conductive metal nitride may include at least one of titanium nitride (TiN), tantalum nitride (TaN), tungsten nitride (WN), nickel nitride (NiN), cobalt nitride (CoN), and platinum nitride (PtN).

Although the first upper contact electrode UCT1 is illustrated as being a double layer including the conductive pattern 210 and the barrier pattern 220, it is only for convenience of explanation, but the present disclosure is not limited thereto.

A metal silicide layer (not shown) may be further disposed between the source/drain pattern 150 and the first upper contact electrode UCT1. The metal silicide layer may include metal silicide.

FIGS. 1, 2A, 2B, and 2C show that the first upper contact electrode UCT1 is disposed on the first source/drain structure 151 and not disposed on the second source/drain structure 152, but the present disclosure is not limited thereto. For example, the first upper contact electrode UCT1 may be respectively disposed on the first source/drain structure 151 and the second source/drain structure 152. The first upper contact electrode UCT1 may be connected to the first source/drain structure 151 and the second source/drain structure 152, respectively. In this case, the first upper contact electrode UCT1 connected to the second source/drain structure 152 may be a dummy contact electrode to which no electrical signal is applied.

The second upper contact electrode UCT2 may be disposed between the gate pattern GS and the upper interconnection structure ML2.

The second upper contact electrode UCT2 may be connected to at least one gate pattern GS.

The second upper contact electrode UCT2 may be disposed on one side of the first upper contact electrode UCT1. The second upper contact electrode UCT2 may be disposed on the main gate structure M_GS.

The second upper contact electrode UCT2 may penetrate at least one capping layer 145. The least one capping layer 145 may contact side surfaces of the second upper contact electrode UCT2. For example, the second upper contact electrode UCT2 may penetrate the capping layer 145 on at least one main gate structure M_GS and be connected to the main gate structure M_GS. The second upper contact electrode UCT2 may not penetrate the interlayer insulating layer 190 on the source/drain pattern 150. For example, the second upper contact electrode UCT2 may not be connected to the source/drain pattern 150.

The lower surface of the second upper contact electrode UCT2 may be, for example disposed at a level similar to that of the upper surface of the main gate structure M_GS. However, the present disclosure is not limited thereto, and the lower surface of the second upper contact electrode UCT2 may be disposed between the lower surface and the upper surface of the main gate structure M_GS.

The second upper contact electrode UCT2 may include a conductive pattern 250 and a barrier pattern 260 configured to surround the conductive pattern 250.

The conductive pattern 250 may include, for example, at least one of a metal, a metal alloy, a conductive metal nitride, a conductive metal carbide, a conductive metal oxide, a conductive metal carbonitride, and a two-dimensional (2D) material.

The barrier pattern 260 may cover sidewalls and a lower surface of the conductive pattern 250. The barrier pattern 260 may contact the sidewalls and the lower surface of the conductive pattern 250. The barrier pattern 260 may include a metal, a metal alloy, or a conductive metal nitride. The metal may include at least one of titanium (Ti), tantalum (Ta), tungsten (W), nickel (Ni), cobalt (Co), and platinum (Pt). The conductive metal nitride may include at least one of titanium nitride (TiN), tantalum nitride (TaN), tungsten nitride (WN), nickel nitride (NiN), cobalt nitride (CoN), and platinum nitride (PtN).

Although the second upper contact electrode UCT2 is illustrated as being a double layer including the conductive pattern 250 and the barrier pattern 260, it is only for convenience of explanation, but the present disclosure is not limited thereto.

A metal silicide layer (not shown) may be further disposed between the main gate structure M_GS and the second upper contact electrode UCT2. The metal silicide layer may include metal silicide.

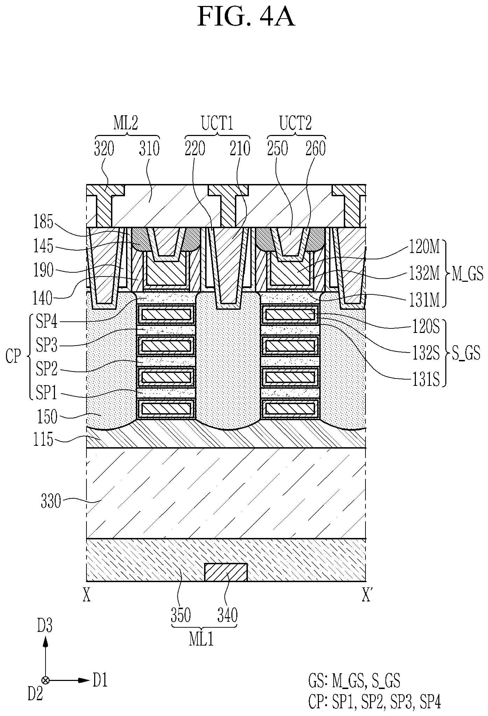

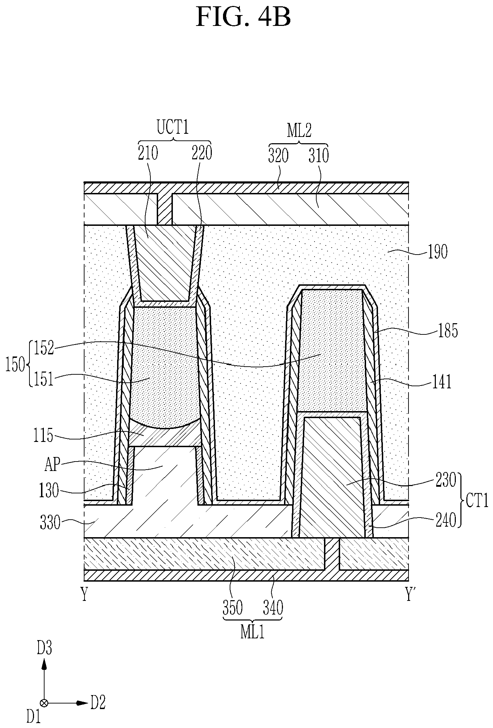

Hereinafter, a semiconductor device 10 according to another embodiment will be described with reference to FIGS. 4A and 4B.

FIGS. 4A and 4B are cross-sectional views corresponding to FIGS. 2A and 2B showing a semiconductor device 10 according to an embodiment.

Since the embodiments shown in FIG. 4A and 4B have substantially the same parts as the embodiment shown in FIGS. 2A and 2B, descriptions thereof will be omitted and differences will be mainly described.

FIGS. 2A and 2B show that the lower pattern layer 110 is disposed on the lower insulating layer 330 and the first conductivity-type doped pattern layer 115 is disposed on the lower pattern layer 110.

In FIGS. 4A and 4B, the first conductivity-type doped pattern layer 115 is disposed on the lower insulating layer 330 and the lower pattern layer 110 is not included.

As illustrated in FIGS. 26A and 26B described later, when a backside power distribution network (BSPDN) structure is applied in the method of manufacturing the semiconductor device 10 according to an embodiment, the entire substrate 100 is removed using the lower pattern layer 110 as an etch-stopping layer (wet stopper), and then the lower pattern layer 110 may also be selectively removed. Accordingly, the manufactured semiconductor device 10 may not include the lower pattern layer 110 between the lower insulating layer 330 and the first conductivity-type doped pattern layer 115.

In this case, the lower contact electrode CT1 may penetrate the first conductivity-type doped pattern layer 115 and be connected to the second source/drain structure 152. For example, the lower contact electrode CT1 may contact a lower surface of the second source/drain structure 152.

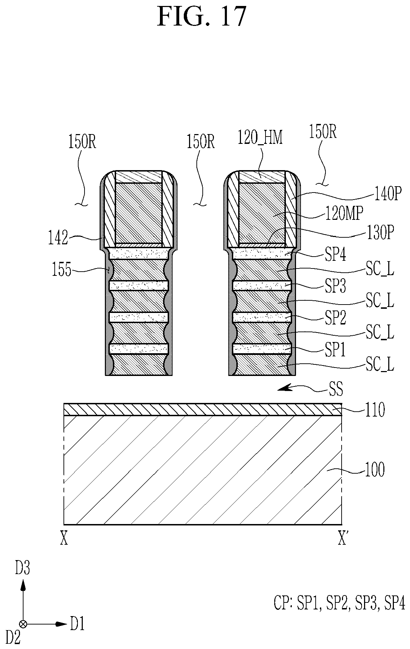

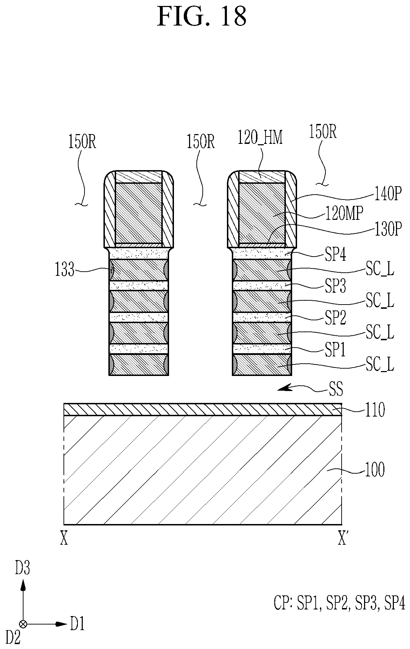

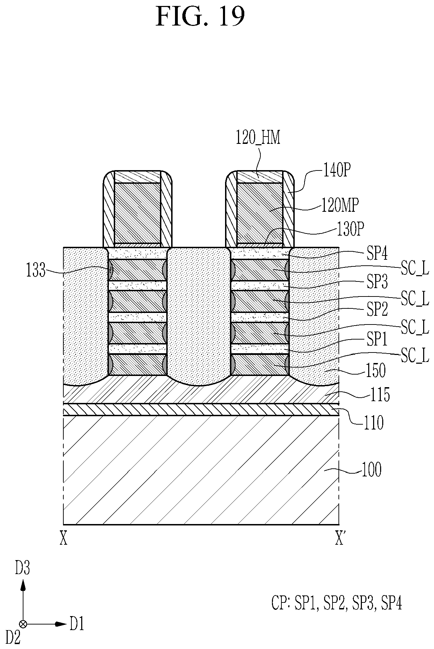

Hereinafter, a method of manufacturing the semiconductor device 10 according to an example embodiment will be described with reference to FIGS. 5A to 29B.

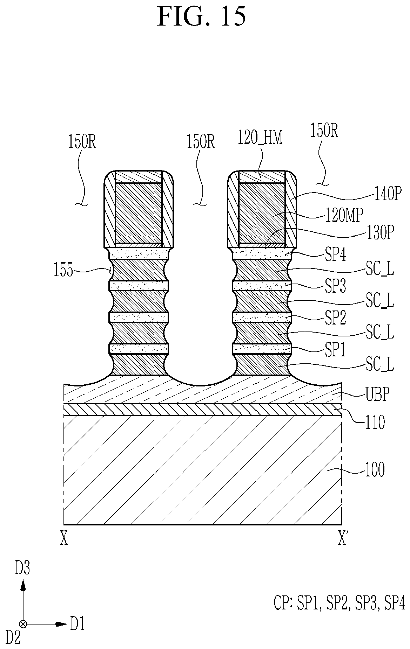

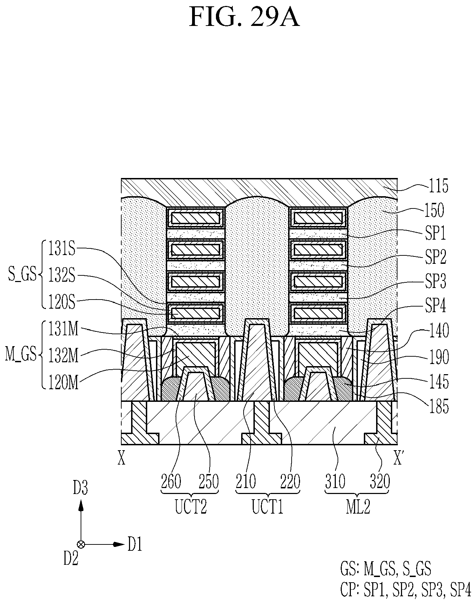

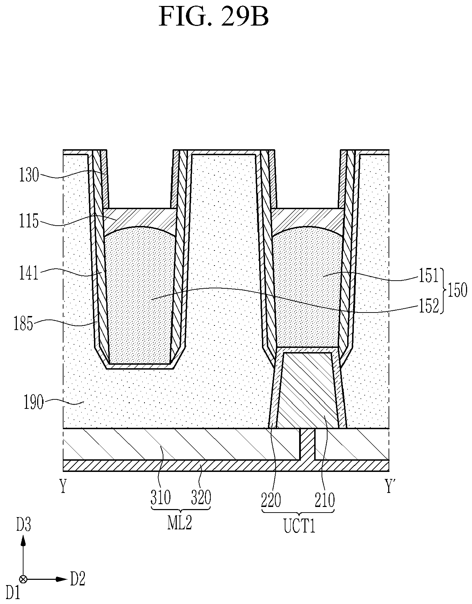

FIGS. 12A to 14B are cross-sectional views showing intermediate steps of a method of manufacturing a semiconductor device 10 according to another example embodiment, FIGS. 15 to 19 are cross-sectional views showing intermediate steps of a method of manufacturing a semiconductor device according to another example embodiment, and FIGS. 29A and 29B are cross-sectional views illustrating an intermediate step of a method of manufacturing a semiconductor device according to another example embodiment.

As shown in FIGS. 5A and 5B, a preliminary lower pattern layer 110P is formed on the substrate 100.

The substrate 100 may include bulk silicon or silicon-on-insulator (SOI). Alternatively, the substrate 100 may include a silicon substrate, or other materials such as silicon germanium (SiGe), silicon germanium on insulator (SGOI), indium antimonide, lead tellurium compound, indium arsenide, Indium phosphide, gallium arsenide, or gallium antimonide.

The preliminary lower pattern layer 110P may include a first semiconductor material having an etching selectivity with that of the substrate 100. For example, the first semiconductor material may include silicon (Si), germanium (Ge), or a combination thereof, and carbon (C), and for example the first semiconductor material may include about 0 at% to about 31.5 at% of the germanium (Ge), greater than about 0 at% and less than or equal to about 2 at% of the carbon (C), and a balance amount of the silicon (Si). The carbon (C) may be included in an amount of about 0.1 at% to about 1 at%.

Subsequently, a preliminary sacrificial lower pattern UBP_P and an upper pattern U_AP are formed on the preliminary lower pattern layer 110P.

The preliminary sacrificial lower pattern UBP_P may be disposed on the preliminary lower pattern layer 110P, and the upper pattern U_AP may be disposed on the preliminary sacrificial lower pattern UBP_P. The upper pattern U_AP may include sacrificial layers SC_L and semiconductor layers ACT_L alternately stacked on the substrate 100.

For example, the preliminary sacrificial lower pattern UBP_P may include silicon (Si), the sacrificial layer SC_L may include silicon germanium (SiGe), and the semiconductor layer ACT_L may include silicon (Si).

As shown in FIGS. 6A and 6B, a sacrificial active pattern AP_P is formed on the substrate 100.

The substrate 100 has a trench defining the sacrificial active patterns AP_P, and a field insulating layer 105 may be disposed in the trench.

The sacrificial active pattern AP_P may have a sheet or fin shape. The sacrificial active patterns AP_P may extend lengthwise along the first direction D1 and may be spaced apart from each other along the second direction D2.

The sacrificial active pattern AP_P may be formed by etching a portion of the substrate 100 or may be formed by etching an epitaxial layer grown from the substrate 100.

The field insulating layer 105 may be disposed on the substrate 100. The field insulating layer 105 may be disposed to fill the trench.

For example, the field insulating layer 105 may be disposed on a sidewall of the sacrificial active pattern AP_P. The field insulating layer 105 is not disposed on the upper surface of the sacrificial active pattern AP_P. The field insulating layer 105 may entirely cover side surfaces of the sacrificial active pattern AP_P. Alternatively, the field insulating layer 105 may cover a portion of the sidewall of the sacrificial active pattern AP_P. In this case, a portion of the sacrificial active pattern AP_P may protrude from the upper surface of the field insulating layer 105 in the third direction D3.

The field insulating layer 105 may include an insulating material, and may include, for example, oxide, nitride, oxynitride, or a combination thereof. Although the field insulating layer 105 is shown as a single layer, it is only for convenience of explanation, and the present disclosure is not limited thereto.

Along with the formation of the sacrificial active pattern AP_P, the lower pattern layer 110 and the sacrificial lower pattern UBP may be formed from the preliminary lower pattern layer 110P and the preliminary sacrificial lower pattern UBP_P.

Subsequently, a preliminary gate insulating layer 130P, a preliminary main gate electrode 120MP, and a preliminary capping layer 120_HM are formed on the upper pattern U_AP.

The preliminary gate insulating layer 130P may also be disposed on both side surfaces of the sacrificial active pattern AP_P and the upper pattern U_AP in the second direction D2.

The preliminary gate insulating layer 130P may include, for example, silicon oxide, but is not limited thereto. The preliminary main gate electrode 120MP may include, for example, polysilicon, but is not limited thereto. The preliminary capping layer 120_HM may include, for example, silicon nitride, but is not limited thereto.

Preliminary gate spacers 140P may be formed on both side surfaces of the preliminary main gate electrode 120MP.

The preliminary gate spacer 140P may also be disposed on both side surfaces of the sacrificial active pattern AP_P and upper pattern U_AP in the second direction D2. In addition, when the preliminary gate insulating layer 130P is disposed on both side surfaces of the sacrificial active pattern AP_P and the upper pattern U_AP in the second direction D2, the preliminary gate spacer 140P may be disposed on the surface of the preliminary gate insulating layer 130P. The preliminary gate spacers 140P disposed on both side surfaces of the sacrificial active pattern AP_P and the upper pattern U_AP in the second direction D2 become the second spacers 141.

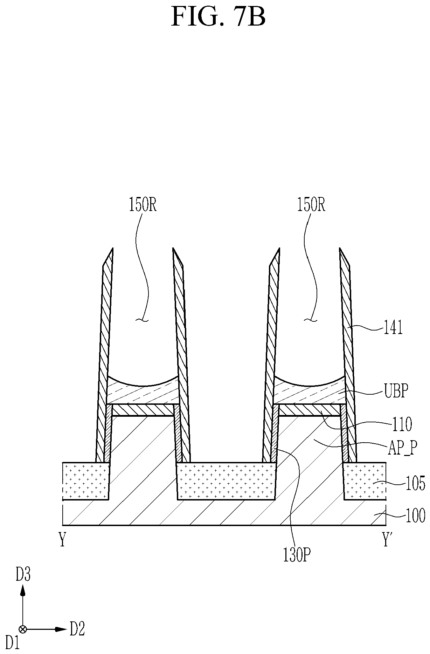

As shown in FIGS. 7A and 7B, at least a portion of the upper pattern U_AP is etched using the preliminary capping layer 120_HM and the preliminary gate spacer 140P as a mask to form the source/drain recess 150R. A portion of the source/drain recess 150R may be formed within the sacrificial active pattern AP_P.

As the source/drain recess 150R is formed, the semiconductor layer ACT_L is separated to form semiconductor patterns SP1, SP2, SP3, and SP4, and the semiconductor patterns SP1, SP2, SP3, and SP4 may be disposed between the source/drain recesses 150R. The semiconductor patterns SP1, SP2, SP3, and SP4 and the sacrificial layer SC_L may be alternately stacked in the third direction D3.

In addition, when the source/drain recess 150R is formed, the preliminary gate insulating layer 130P disposed on the side surface of the source/drain recess 150R is removed together, the preliminary gate insulating layer 130P remaining at the side surface of the sacrificial active pattern AP_P may become a first spacer 130.

In addition, when the source/drain recess 150R is formed, a portion of the second spacer 141 may be etched. Accordingly, the second spacer 141 may cover the entire surface of the source/drain pattern 150 but is not limited thereto, and the second spacer 141 may cover a portion of the side surface of the source/drain pattern 150. In other words, a top height of the second spacer 141 in the third direction D3 may be the same as that of the source/drain pattern 150 in the third direction D3 or lower than that of the source/drain pattern 150 in the third direction D3.

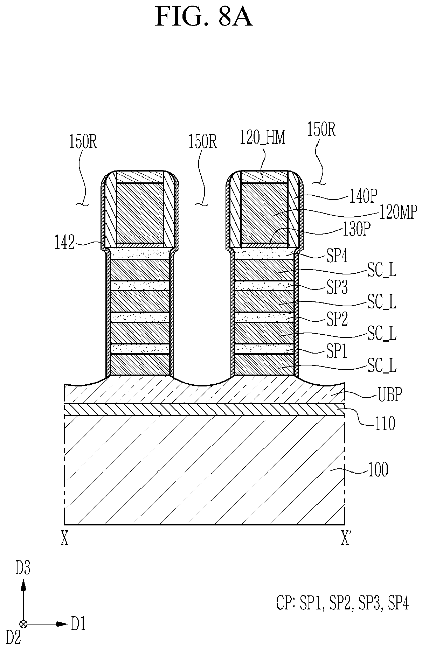

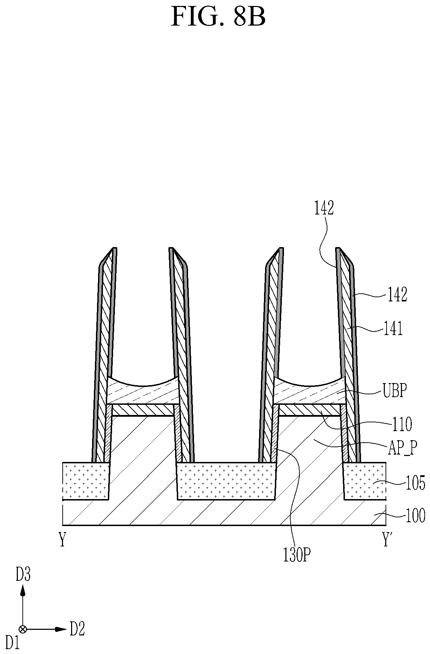

As shown in FIGS. 8A and 8B, a third spacer 142 may be formed on the side surfaces of the semiconductor patterns SP1, SP2, SP3, and SP4, the sacrificial layer SC_L, and the preliminary gate spacer 140P.

The third spacer 142 is formed by first forming a preliminary third spacer on the preliminary capping layer 120_HM, the semiconductor patterns SP1, SP2, SP3, and SP4, the sacrificial layer SC_L, the preliminary gate spacer 140P, the field insulating layer 105, and the sacrificial lower pattern UBP and then, removing the upper surface of the preliminary third spacer through an etching process.

The third spacer 142 may cover the side surface of the semiconductor patterns SP1, SP2, SP3, and SP4 and the sacrificial layer SC_L in the source/drain recess 150R, but not the upper surface of the sacrificial lower pattern UBP. The third spacer 142 may cover the side surface of the preliminary gate spacer 140P but not the upper surface of the preliminary capping layer 120_HM.

The third spacer 142 may include a silicon nitride. However, the present invention is not limited thereto, and the material of the third spacer 142 may be variously changed. For example, the third spacer 142 may be formed of SiOCN and the like.

As shown in FIGS. 9A and 9B, the sacrificial lower pattern UBP disposed under the source/drain recess 150R and under the semiconductor patterns SP1, SP2, SP3, and SP4 is selectively removed.

Herein, the semiconductor patterns SP1, SP2, SP3, and SP4, the sacrificial layer SC_L, and the preliminary gate spacer 140P may not be removed, but the sacrificial lower pattern UBP may be exclusively removed in areas not covered by the third spacer 142.

In addition, when the sacrificial lower pattern UBP is removed, as the lower pattern layer 110 includes the first semiconductor material having etching selectivity with the sacrificial lower pattern UBP and the substrate 100, the lower pattern layer 110 may work as an etch-stopping layer (wet stopper) to prevent etching of the substrate 100.

For example, the sacrificial lower pattern UBP may be removed by using a wet etching process.

Herein, an etching solution may be selected not to remove the first semiconductor material included in the lower pattern layer 110 but to remove the second semiconductor material included in the sacrificial lower pattern UBP.

In other words, the etching solution used to remove the lower pattern layer 110 may have a relatively higher etch rate for the second semiconductor material of the sacrificial lower pattern UBP than the first semiconductor material of the lower pattern layer 110.

For example, the first semiconductor material of the lower pattern layer 110 may include silicon (Si), germanium (Ge), and carbon (C) (SiGe:C), and the second semiconductor material of the sacrificial lower pattern UBP may include silicon (Si).

Herein, the etching process is performed by using an etching solution that has a higher etch rate for Si than that for SiGe:C, exclusively etching the sacrificial lower pattern UBP. Accordingly, the lower pattern layer 110 and the substrate 100 under the same are not removed, but the sacrificial lower pattern UBP may be exclusively removed. Where the sacrificial lower pattern UBP is positioned, an empty space SS may be formed.

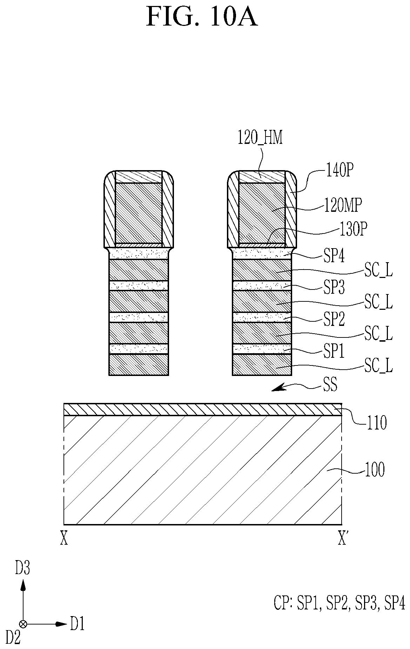

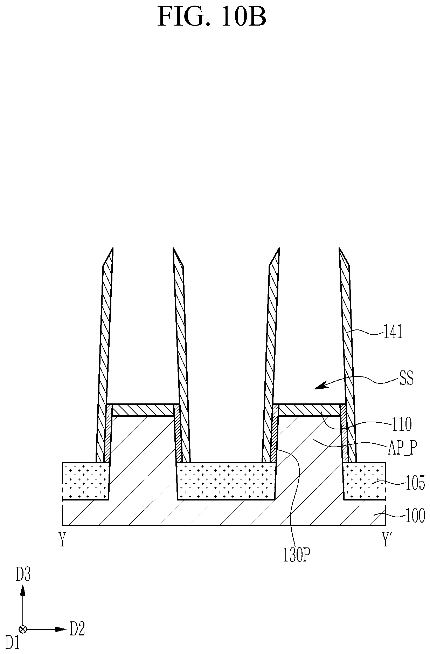

On the other hand, in the process of exclusively removing the sacrificial lower pattern UBP, the preliminary gate insulating layer 130P may be partially or entirely removed. Herein, where the preliminary gate insulating layer 130P is removed, dents are formed, and since at least some of the dents are filled with the source/drain pattern 150, the source/drain pattern 150 may be disposed at both side surfaces of the lower pattern layer 110 in the second direction D2. As shown in FIGS. 10A and 10B, the third spacer 142 is removed through the etching process.

As the third spacer 142 is removed, the side surfaces of the semiconductor patterns SP1, SP2, SP3, and SP4 and the sacrificial layer SC_L are exposed in the source/drain recess 150R. In addition, the third spacer 142 covering the side surface of the preliminary gate spacer 140P is removed.

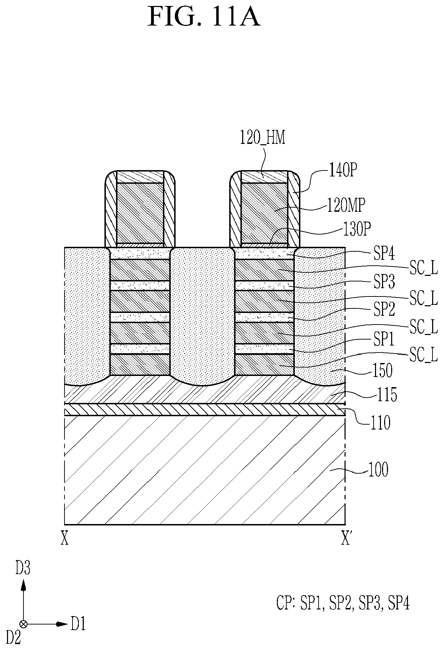

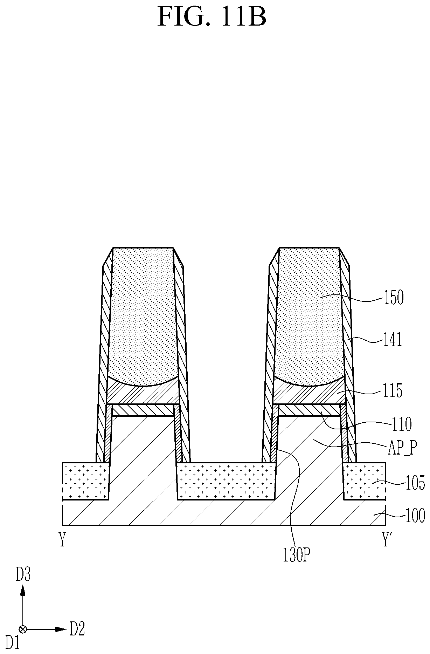

As shown in FIGS. 11A and 11B, the first conductivity-type doped pattern layer 115 and the source/drain pattern 150 may be sequentially formed through one process.

The first conductivity-type doped pattern layer 115 and the source/drain pattern 150 may be formed in an epitaxial growth method. The upper surface of the lower pattern layer 110 and an interior wall of the source/drain recess 150R may be used as seeds. The interior wall of the source/drain recess 150R consists of the side surfaces of the semiconductor patterns SP1, SP2, SP3, and SP4 and the sacrificial layer SC_L and the upper surface of the lower pattern layer 110.

The first conductivity-type doped pattern layer 115 is formed in the empty space SS where the sacrificial lower pattern UBP is positioned, and the source/drain pattern 150 is formed in the source/drain recess 150R.

Herein, the first conductivity-type doped pattern layer 115 is first formed, and then, the source/drain pattern 150 is formed by controlling a growth rate along the plane direction of a wafer. For example, when a plane (100) of the wafer has a higher growth rate than that of a plane (110), as an epitaxial layer grows in the third direction D3, the first conductivity-type doped pattern layer 115 may grow in the empty space SS where the sacrificial lower patterns UBP are present, but when the plane (110) of the wafer has a higher growth rate than that of the plane (100), as the epitaxial layer grows in the first direction D1, the source/drain pattern 150 may grow in the source/drain recess 150R.

As described above, the first conductivity-type doped pattern layer 115 may include a semiconductor material doped with first conductivity-type impurities, and the source/drain pattern 150 may include a semiconductor material doped with second conductivity-type impurities differing from the first conductivity-type impurities.

For example, when the source/drain pattern 150 includes a semiconductor material doped with n-type impurities, the first conductivity-type doped pattern layer 115 may include a semiconductor material doped with p-type impurities.

In addition, when the source/drain pattern 150 includes the semiconductor material doped with the p-type impurities, the first conductivity-type doped pattern layer 115 may include the semiconductor material doped with the n-type impurities.

For example, when the source/drain pattern 150 includes the semiconductor material doped with the n-type impurities, while the first conductivity-type doped pattern layer 115 includes the semiconductor material doped with the p-type impurities, at the beginning of the epitaxial growth, boron (B) is used as an impurity gas under a condition that the plane (100) has a dominant growth rate, but in the later epitaxial growth, phosphorus (P) may be used as an impurity gas under a condition that the plane (110) has a dominant growth rate.

On the other hand, the first conductivity-type doped pattern layer 115 and the source/drain pattern 150 are not sequentially formed through one process, but as shown in FIGS. 12A to 14B, after forming the first conductivity-type doped pattern layer 115, the source/drain pattern 150 may be formed in the subsequent process.

Herein, the third spacer 142 is not removed, but the first conductivity-type doped pattern layer 115 may be formed under the presence of the third spacer 142.

For example, when the source/drain pattern 150 includes the semiconductor material doped with the n-type impurities, and the first conductivity-type doped pattern layer 115 includes the semiconductor material doped with the p-type impurities, the first conductivity-type doped pattern layer 115 may be formed through epitaxial growth by using boron (B) as an impurity gas under the condition that the plane (100) has a dominant growth rate.

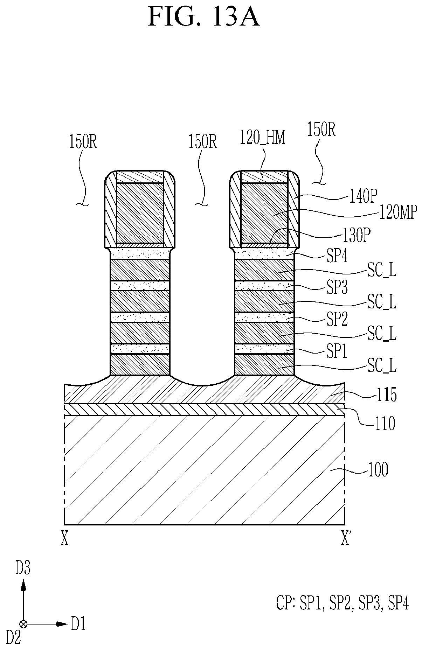

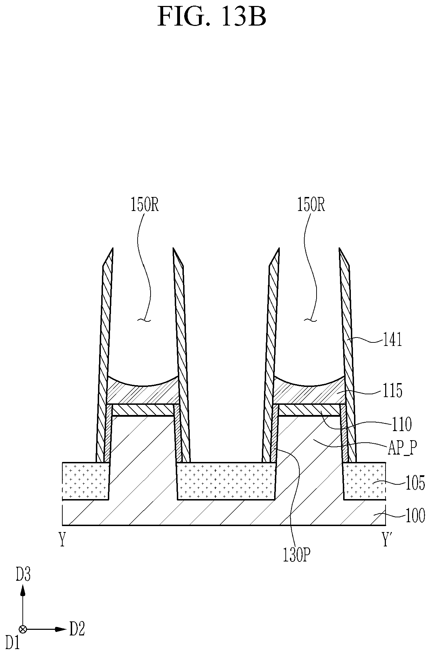

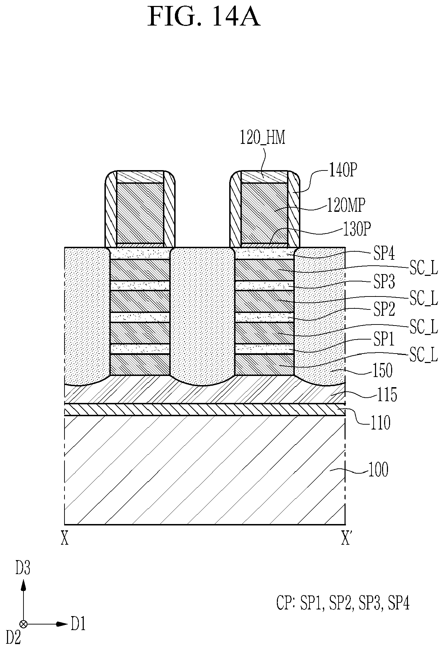

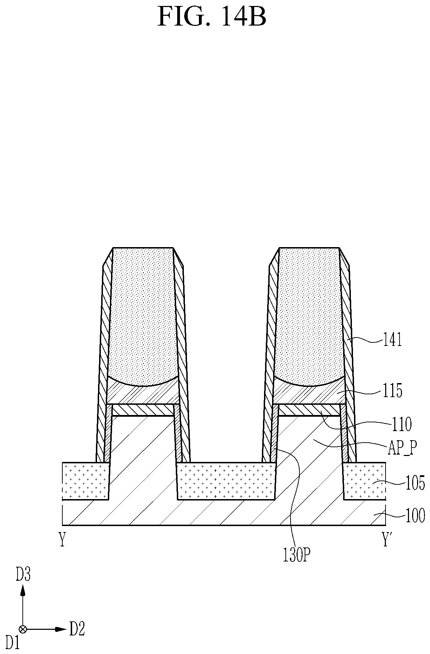

Subsequently, as shown in FIGS. 13A and 13B, the third spacer 142 is removed through an etching process, and as shown in FIGS. 14A and 14B, the source/drain pattern 150 is formed in the source/drain recess 150R. Herein, the bottom surface of the source/drain recess 150R may be the upper surface of the first conductivity-type doped pattern layer 115.

For example, when the source/drain pattern 150 including the semiconductor material doped with the n-type impurities, while the first conductivity-type doped pattern layer 115 includes the semiconductor material doped with the p-type impurities, the source/drain pattern 150 may be formed through epitaxial growth by using phosphorus (P) as an impurity gas under the condition that the plane (110) has a dominant growth rate.

On the other hand, as shown in FIG. 15, after forming the source/drain recess 150R, an indent process for sacrificial layer SC_L may proceed.

In the indent process, a wet or dry etching method may be used to etch the sacrificial layer SC_L to further reduce a length of the sacrificial layer SC_L in the first direction (D1), forming indents 155. Accordingly, the surface of the sacrificial layer SC_L in contact with the source/drain recess 150R has a concave shape toward the source/drain recess 150R.

For example, when using a wet etching method, an etching solution such as ammonia water may be used.

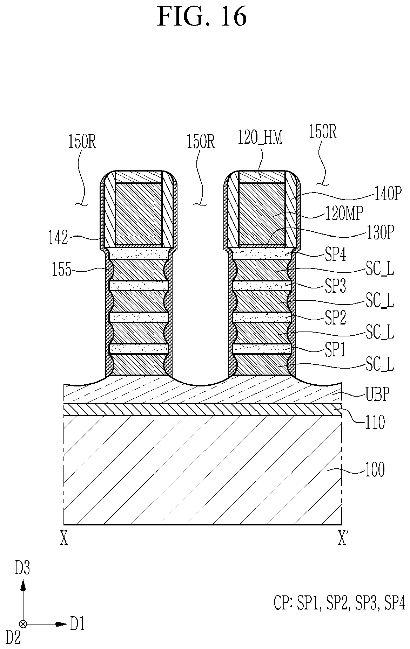

Subsequently, as shown in FIGS. 16 to 19, after forming the third spacer 142 on the side surfaces of the semiconductor patterns SP1, SP2, SP3, and SP4, the sacrificial layer SC_L, and the preliminary gate spacer 140P and then, exclusively removing the sacrificial lower pattern UBP under the source/drain recess 150R, the third spacer 142 is removed by using the etching process.

However, even though the third spacer 142 is removed, the third spacer 142 inside the indents155 remains, forming the inner gate spacer 133.

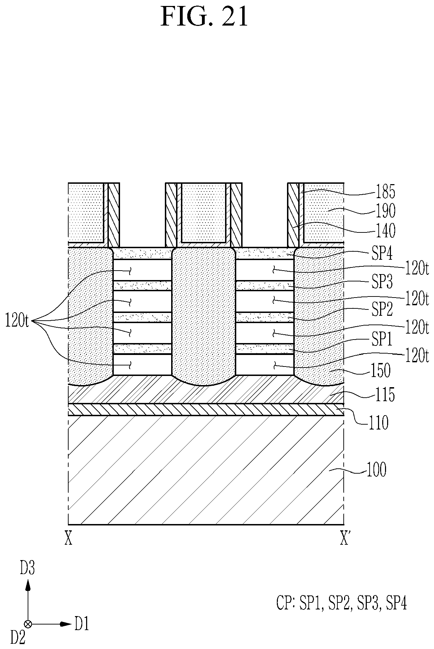

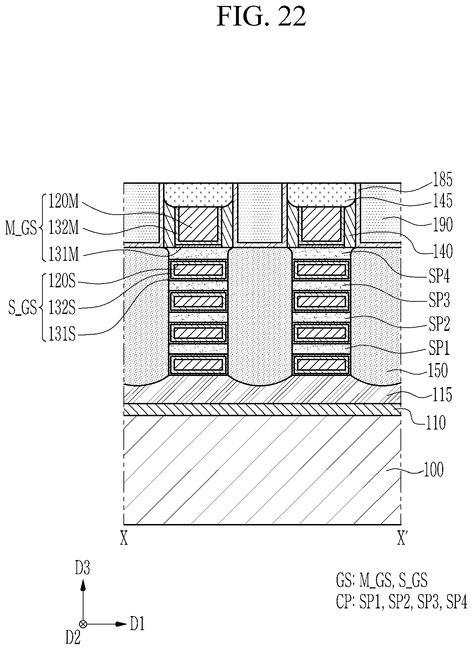

Subsequently, when the first conductivity-type doped pattern layer 115 and the source/drain pattern 150 are formed, as shown in FIG. 3, the inner gate spacer 133 may be disposed between the sacrificial layer SC_L and the source/drain pattern 150. In addition, as shown in FIGS. 21 and 22 described later, after removing the sacrificial layer SC_L, sub-gate structures S_GS are formed where the sacrificial layer SC_L used to be positioned, the inner gate spacer 133 may be positioned between the sub-gate structures S_GS and the source/drain pattern 150.

The inner gate spacer 133 may include a low dielectric constant material. The low dielectric constant material may include a silicon oxide or a material having a lower dielectric constant than that of the silicon oxide. For example, the low dielectric constant material may include a silicon oxide, a silicon oxide doped with fluorine or carbon, a porous silicon oxide, or an organic polymer dielectric material. For another example, the inner gate spacer 133 may include at least one selected from a silicon nitride, a silicon carbonate, a silicon carbonate nitride, and a silicon oxynitride.

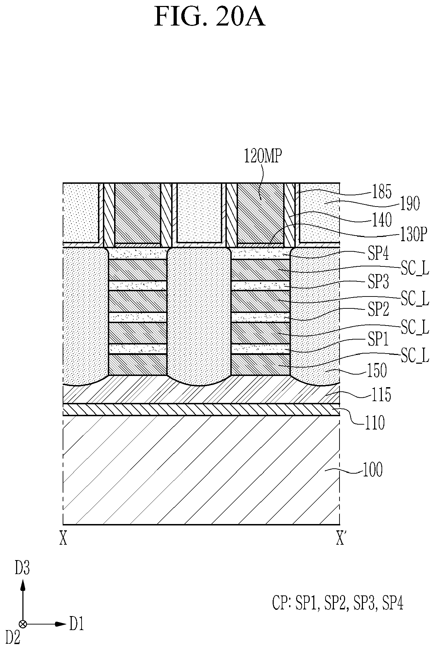

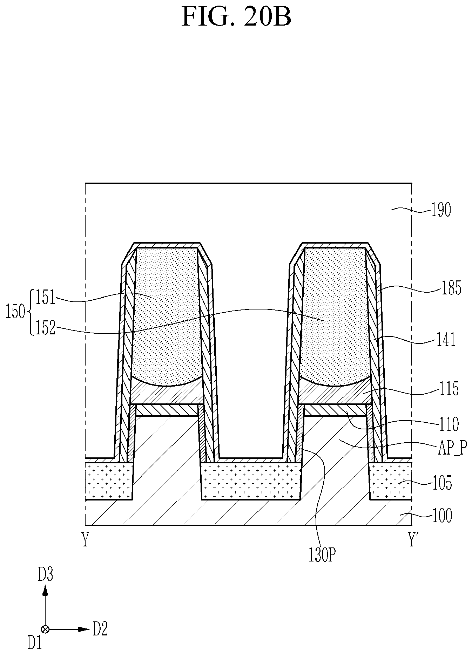

Next, as shown in FIGS. 20A and 20B, an etch-stopping layer 185 and an interlayer insulating layer 190 are sequentially formed on the source/drain pattern 150.

Subsequently, a portion of the interlayer insulating layer 190, a portion of the etch-stopping layer 185, and the preliminary capping layer 120_HM are removed to expose an upper surface of the preliminary main gate electrode 120MP. While the upper surface of the preliminary main gate electrode 120MP is exposed, the gate spacer 140 may be formed.

As shown in FIG. 21, the preliminary gate insulating layer 130P and the preliminary main gate electrode 120MP disposed on the upper pattern structure U_AP are removed to expose the upper pattern structure U_AP between the gate spacers 140. Subsequently, gate trenches 120t are formed between the semiconductor patterns SP1, SP2, SP3, and SP4 and below the first semiconductor pattern SP1.

As shown in FIG. 22, a sub-interface insulating layer 131S, a sub-gate insulating layer 132S, and a sub-gate electrode 120S may be sequentially formed in the gate trenches 120t. In addition, a main interface insulating layer 131M, a main gate insulating layer 132M, a main gate electrode 120M, and a capping layer 145 may be sequentially formed.

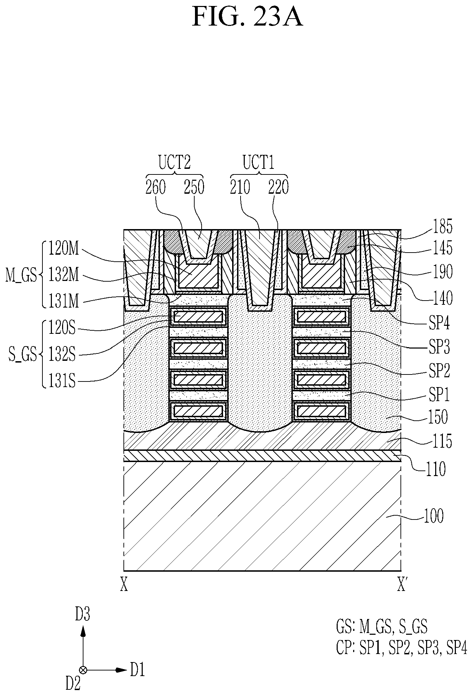

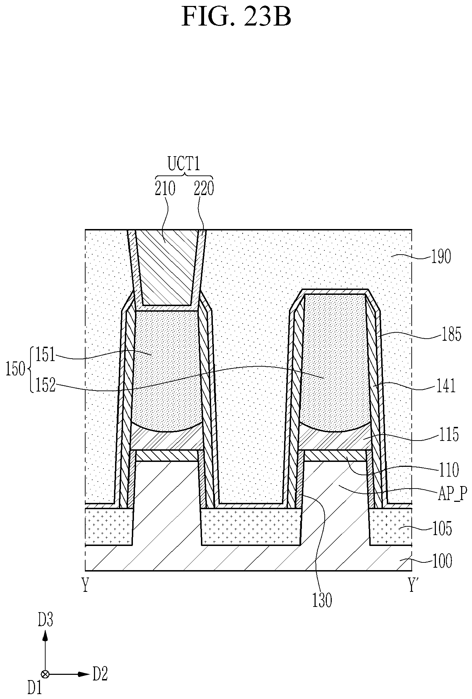

As shown in FIGS. 23A and 23B, the first upper contact electrode UCT1 is formed within the interlayer insulating layer 190.

First, a contact hole may be formed by penetrating the interlayer insulating layer 190 to expose the source/drain pattern 150. For example, the contact hole may be formed by penetrating the interlayer insulating layer 190 to expose the first source/drain structure 151. A contact hole exposing the second source/drain structure 152 may not be formed but is not limited thereto.

Subsequently, a first upper contact electrode UCT1 filling the contact hole and electrically connected to the first source/drain structure 151 is formed. For example, in the contact hole, a barrier pattern 220 and a conductive pattern 210 are sequentially formed. Accordingly, the first upper contact electrode UCT1 may be electrically connected to the first source/drain structure 151 by penetrating an interlayer insulating layer 191.

In addition, in the capping layer 145, a second upper contact electrode UCT2 is formed.

First, a contact hole may be formed by penetrating the capping layer 145 to expose a main gate structure M_GS.

Subsequently, the second upper contact electrode UCT2 may be formed to fill the contact hole and be electrically connected to the main gate structure M_GS. For example, in the contact hole, a barrier pattern 260 and a conductive pattern 250 are sequentially formed. Accordingly, the second upper contact electrode UCT2 may be electrically connected to the main gate structure M_GS by penetrating the capping layer 145.

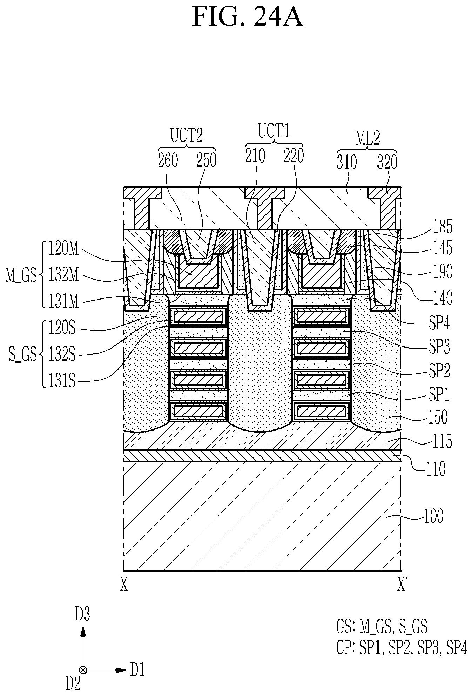

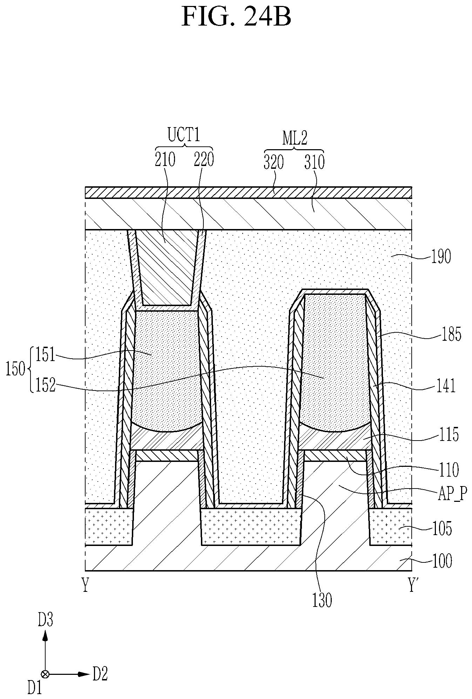

As shown in FIGS. 24A and 24B, an upper interconnection structure ML2 electrically connected to the first upper contact electrode UCT1 is formed on the upper surface of the interlayer insulating layer 190 and the capping layer 145. However, the present invention is not limited thereto, but the upper interconnection structure ML2 may be electrically connected to the second upper contact electrode UCT1.

The upper interconnection structure ML2 may include first upper interconnections 320 and an upper interconnection insulating layer 310 covering the first upper interconnections 320.

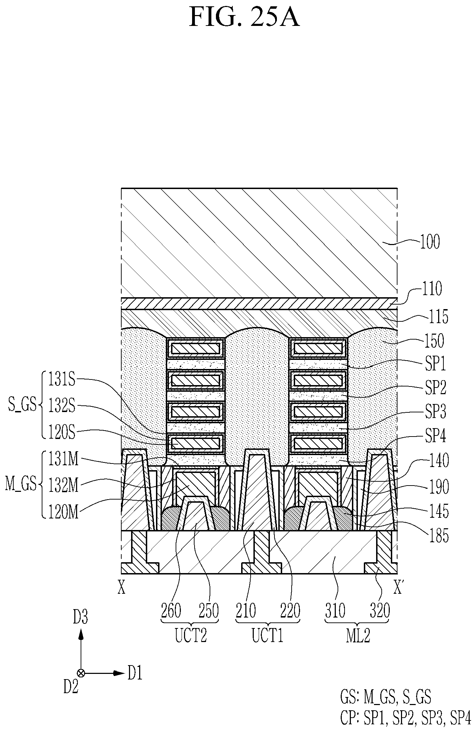

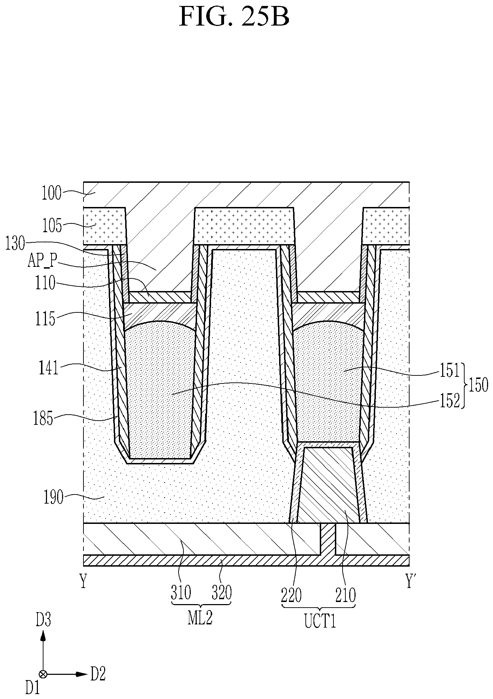

As shown in FIGS. 25A and 25B, the semiconductor device 10 according to an embodiment is rotated.

For example, the rotated semiconductor device 10 may be disposed on a carrier substrate (not shown). Herein, after positioning the upper surface of the semiconductor device 10 to face the carrier substrate, the semiconductor device 10 may be attached to the carrier substrate. In other words, the upper interconnection structure ML2 on the upper surface of the semiconductor device 10 may be attached onto the carrier substrate. Between the upper interconnection structure ML2 and the carrier substrate, an adhesive member (not shown) may be disposed.

The carrier substrate substantially has the same area as or a larger area than that of the semiconductor device 10. The carrier substrate may be, for example, a semiconductor wafer, a ceramic substrate, or a glass substrate. The adhesive member may be formed into a film.

The adhesive member may include a base film and an adhesive layer attached to both surfaces of the base film. The base film may be, for example, a polyethylene-based film such as polyethylene terephthalate (PET) or polyethylene-2,6-naphthalenedicarboxylate (PEN) or a polyolefin-based film. The base film may be formed by coating a polyethylene film or a polyolefin film with silicone or TEFLON (tetrafluoroethylene). The adhesive layer may be made of, for example, an acrylic polymer resin, an epoxy resin, or a mixture thereof.

As shown in FIGS. 26A and 26B, the substrate 100 may be removed by performing an etching process. The etching process may be performed by, for example, a wet etching method, but is not limited thereto.

In this case, since the lower pattern layer 110 includes the first semiconductor material having an etching selectivity with the substrate 100, the lower pattern layer 110 may serve as an etch-stopping layer. For example, in the process of etching the substrate 100, if the lower pattern layer 110 is exposed, the etching process may be stopped. In this way, even in the process of removing the entire substrate 100 when a backside power distribution network (BSPDN) structure is applied in the method of manufacturing the semiconductor device 10 according to an embodiment, by using the lower pattern layer 110 as an etch-stopping layer (wet stopper), the BSPDN bulk-less structure (a structure in which all silicon substrates are removed) can be easily implemented through an etching selectivity.

The etching process of the substrate 100 may be performed by using an etching solution with a relatively high etch rate for the substrate 100. For example, when the substrate 100 includes Si, and the lower pattern layer 110 includes SiGe:C, the etching process may be performed by using an etching solution with a relatively high etch rate for Si.

As the substrate 100 is removed, the lower pattern layer 110 may be exposed.

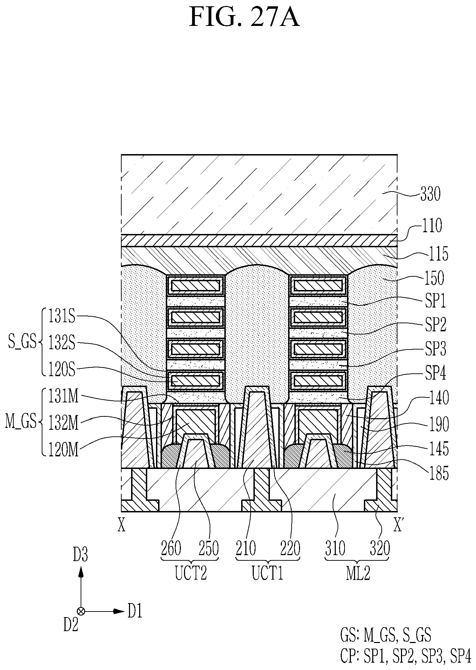

As shown in FIGS. 27A and 27B, a lower insulating layer 330 may be formed to cover the lower pattern layer 110. Accordingly, the lower insulating layer 330 may contact the lower pattern layer 110.

The lower insulating layer 330 may be formed by forming a preliminary lower insulating layer to cover the lower pattern layer 110 and performing chemical mechanical polishing (CMP) to planarize the upper surface of the lower insulating layer 330, but the present invention is not limited thereto.

In FIGS. 26A to 27B, after removing the substrate 100 through the etching process, the lower insulating layer 330 is formed where the substrate 100 is removed, but the present invention is not limited thereto, and the process of FIGS. 26A to 27B may be omitted. For example, the substrate 100 may not be entirely removed by etching, but a portion thereof may be selectively removed by etching. Herein, the substrate 100 may be patterned through a photo and etching process to expose the lower pattern layer 110. Or, the substrate 100 may not be completely removed through the etching process, but a portion of the substrate 100 may be selectively removed to expose the lower pattern layer 110.

Subsequently, a portion of the lower insulating layer 330 is removed through the photo and etching process to form a contact hole exposing the second source/drain structure 152. Herein, the contact hole may penetrate the lower pattern layer 110 and the first conductivity-type doped pattern layer 115. A side surface of the contact hole may be, for example, surrounded with the lower insulating layer 330.

Subsequently, a lower contact electrode CT1 is formed to fill a contact and be electrically connected to the second source/drain structure 152. For example, in the contact hole, a barrier pattern 240 and a conductive pattern 230 are sequentially formed. Accordingly, the lower contact electrode CT1 may be electrically connected to the second source/drain structure 152 by penetrating the lower pattern layer 110 and the first conductivity-type doped pattern layer 115.

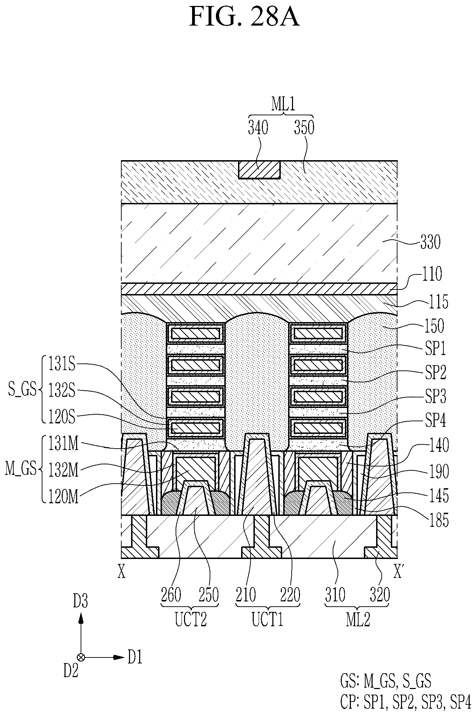

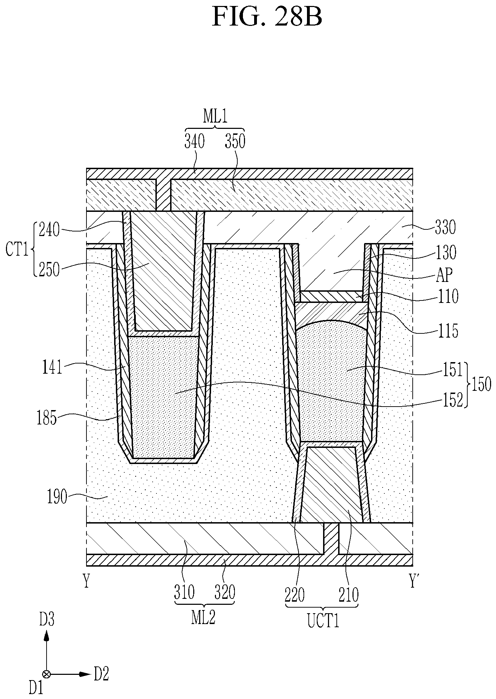

As shown in FIGS. 28A and 28B, on the lower surface of the lower insulating layer 330, the lower interconnection structure ML1 electrically connected to the lower contact electrode CT1 is formed. The lower interconnection structure ML1 may include lower interconnections 340 and a lower interconnection insulating layer 350 covering the lower interconnections 340.

Subsequently, after removing the carrier substrate and the adhesive member, the semiconductor device 10 is rotated, forming the semiconductor device 10 of FIG. 1, FIG. 2A, FIG. 2B, and FIG. 2C.

On the other hand, as shown in FIGS. 26A and 26B, after removing the substrate 100, as shown in FIG. 29A and 29B, the lower pattern layer 110 may be selectively removed.

For example, when a backside power distribution network (BSPDN) structure is applied in the method of manufacturing the semiconductor device 10 according to an embodiment, the entire substrate 100 is removed using the lower pattern layer 110 as an etch-stopping layer (wet stopper), and then the lower pattern layer 110 may also be selectively removed.

The lower pattern layer 110 may be removed using an etching process. The etching process may be performed by, for example, a wet etching method, but is not limited thereto.

The etching process of the lower pattern layer 110 may be performed by using an etching solution with a relatively high etch rate for the lower pattern layer 110. For example, when the lower pattern layer 110 includes SiGe:C, an etching solution with a relatively high etch rate for SiGe:C may be used to perform the etching process.

Subsequently, after forming the lower insulating layer 330 to cover the first conductivity-type doped pattern layer 115 exposed as the lower pattern layer 110 is removed, forming the lower contact electrode CT1 electrically connected to the second source/drain structure 152, and forming the lower interconnection structure ML1 electrically connected to the lower contact electrode CT1 on the lower surface of the lower insulating layer 330, the semiconductor device 10 is rotated, forming the semiconductor device 10 of FIGS. 4A and 4B.

It is to be understood that the invention is not limited to the disclosed embodiments, but, on the contrary, is intended to cover various modifications and equivalent arrangements included within the scope of the appended claims.

### <Description of Symbols>

10: semiconductor device
100: substrate
105: field insulating layer
110: lower pattern layer
115: first conductivity-type doped pattern layer
AP: active pattern
CP: channel pattern
SP1, SP2, SP3, SP4: semiconductor pattern
GS: gate pattern
M_GS: main gate portion
120M: main gate electrode
131 M: main interface insulating layer
132M: main gate insulating layer
S_GS: sub-gate portion
120S: sub-gate electrode
131S: sub-interface insulating layer
132S: sub-gate insulating layer
133: inner gate spacer
140: gate spacer
141: second spacer
142: third spacer
130: first spacer
145: capping layer
150: source/drain pattern
151: first source/drain structure
152: second source/drain structure
150R: source/drain recess
185: etch-stopping layer
190: interlayer insulating layer
CT1: lower contact electrode
230: conductive pattern
240: barrier pattern
UCT1: first upper contact electrode
210: conductive pattern
220: barrier pattern
UCT2: second upper contact electrode
250: conductive pattern
260: barrier pattern
ML1: lower interconnection structure
350: lower interconnection insulating layer
340: lower interconnection
ML2: upper interconnection structure
310: upper interconnection insulating layer
320: upper interconnection
330: lower insulating layer
AP_P: sacrificial active pattern
U_AP: upper pattern
SC_L: sacrificial layer
ACT_L: semiconductor layer
UBP: sacrificial lower pattern
UBP_P: preliminary sacrificial lower pattern
110P: preliminary lower pattern layer
120MP: preliminary main gate electrode
120_HM: preliminary capping layer
130P: preliminary gate insulating layer
140P: preliminary gate spacer
150R: source/drain recess
155: indent

## Claims

1. A semiconductor device comprising:
a lower pattern layer including a first semiconductor material;
a first conductivity-type doped pattern layer disposed on the lower pattern layer and including a semiconductor material doped with a first conductivity-type impurity;
a source/drain pattern disposed on the first conductivity-type doped pattern layer and including a semiconductor material doped with a second conductivity-type impurity different from the first conductivity-type impurity;
a channel pattern including semiconductor patterns connected between the source/drain patterns, stacked apart from each other, and including a second semiconductor material different from the first semiconductor material; and
a gate pattern disposed on the first conductivity-type doped pattern layer and between the source/drain patterns, and surrounding the channel pattern.

2. The semiconductor device of claim 1, wherein the first semiconductor material includes silicon, Si, germanium, Ge, or a combination thereof, and carbon, C.

3. The semiconductor device of claim 2, wherein the first semiconductor material includes about 0 at% to about 31.5 at% of the germanium, Ge, greater than about 0 at% and less than or equal to about 2 at% of the carbon, C, and a balance amount of the silicon, Si.

4. The semiconductor device of any preceding claim, wherein the second semiconductor material includes silicon, Si, germanium, Ge, or a combination thereof.

5. The semiconductor device of any preceding claim, wherein the first conductivity-type impurity is an n-type impurity, and the second conductivity-type impurity is a p-type impurity.

6. The semiconductor device of claim 5,
wherein the n-type impurity includes phosphorus, P, arsenic, As, antimony, Sb, or a combination thereof, and
wherein the p-type impurity includes boron, B, aluminum, Al, gallium, Ga, indium, In, or a combination thereof.

7. The semiconductor device of any of claims 1 to 4, wherein the first conductivity-type impurity is a p-type impurity, and the second conductivity-type impurity is an n-type impurity.

8. The semiconductor device of claim 7,
wherein the n-type impurity includes phosphorus, P, arsenic, As, antimony, Sb, or a combination thereof, and
wherein the p-type impurity includes boron, B, aluminum, Al, gallium, Ga, indium, In, or a combination thereof.

9. The semiconductor device of any preceding claim, wherein the first conductivity-type doped pattern layer is an epitaxial layer.

10. The semiconductor device of any preceding claim,
wherein the gate pattern has a main gate portion disposed on the semiconductor patterns and sub-gate portions disposed between the semiconductor patterns, and
wherein the semiconductor device further includes an inner gate spacer disposed between the sub-gate portions of the gate pattern and the source/drain pattern.

11. The semiconductor device of any preceding claim, wherein
the semiconductor device further includes a lower contact electrode disposed under the source/drain pattern and connected to the source/drain pattern by penetrating the lower pattern layer and the first conductivity-type doped pattern layer.

12. The semiconductor device of claim 11,
wherein the source/drain pattern includes a first source/drain structure and a second source/drain structure spaced apart from each other, and
wherein the semiconductor device further includes a first upper contact electrode disposed on the first source/drain structure and connected to the first source/drain structure.

13. The semiconductor device of claim 12 or 13, wherein the lower contact electrode is disposed under the second source/drain structure and connected to the second source/drain structure.

14. The semiconductor device of any of claims 12 to 14, wherein the semiconductor device further includes a second upper contact electrode disposed on the gate pattern and connected to the gate pattern.

15. The semiconductor device of any of claims 12 to 14, wherein
the semiconductor device further includes a lower insulating layer disposed under the lower pattern layer, and
the lower contact electrode is connected to the source/drain pattern by penetrating the lower insulating layer.

## Amended claims

### Amended claims in accordance with Rule 137(2) EPC.

1. A semiconductor device comprising:
a lower pattern layer (110) disposed on an active pattern (AP) and including a first semiconductor material;
a first conductivity-type doped pattern layer (115) disposed on the lower pattern layer and including a semiconductor material doped with a first conductivity-type impurity;
a source/drain pattern (150), wherein at least a part of the source/drain pattern is disposed on the first conductivity-type doped pattern layer and including a semiconductor material doped with a second conductivity-type impurity different from the first conductivity-type impurity;
a channel pattern (CP) including semiconductor patterns (SP1-4) connected between the source/drain patterns, stacked apart from each other, and including a second semiconductor material different from the first semiconductor material; and
a gate pattern (GS) disposed on the first conductivity-type doped pattern layer and between the source/drain patterns, and surrounding the channel pattern.

2. The semiconductor device of claim 1, wherein the first semiconductor material includes silicon, Si, germanium, Ge, or a combination thereof, and carbon, C.

3. The semiconductor device of claim 2, wherein the first semiconductor material includes about 0 at% to about 31.5 at% of the germanium, Ge, greater than about 0 at% and less than or equal to about 2 at% of the carbon, C, and a balance amount of the silicon, Si.

4. The semiconductor device of any preceding claim, wherein the second semiconductor material includes silicon, Si, germanium, Ge, or a combination thereof.

5. The semiconductor device of any preceding claim, wherein the first conductivity-type impurity is an n-type impurity, and the second conductivity-type impurity is a p-type impurity.

6. The semiconductor device of claim 5,
wherein the n-type impurity includes phosphorus, P, arsenic, As, antimony, Sb, or a combination thereof, and
wherein the p-type impurity includes boron, B, aluminum, Al, gallium, Ga, indium, In, or a combination thereof.

7. The semiconductor device of any of claims 1 to 4, wherein the first conductivity-type impurity is a p-type impurity, and the second conductivity-type impurity is an n-type impurity.

8. The semiconductor device of claim 7,
wherein the n-type impurity includes phosphorus, P, arsenic, As, antimony, Sb, or a combination thereof, and
wherein the p-type impurity includes boron, B, aluminum, Al, gallium, Ga, indium, In, or a combination thereof.

9. The semiconductor device of any preceding claim, wherein the first conductivity-type doped pattern layer is an epitaxial layer.

10. The semiconductor device of any preceding claim,
wherein the gate pattern (GS) has a main gate portion (M_GS) disposed on the semiconductor patterns (CP) and sub-gate portions (S_GS) disposed between the semiconductor patterns, and
wherein the semiconductor device further includes an inner gate spacer (133) disposed between the sub-gate portions of the gate pattern and the source/drain pattern (150).

11. The semiconductor device of any preceding claim, wherein
the semiconductor device further includes a lower contact electrode (CT1) disposed under the source/drain pattern (150) and connected to the source/drain pattern by penetrating the lower pattern layer (110) and the first conductivity-type doped pattern layer (115).

12. The semiconductor device of claim 11,
wherein the source/drain pattern (150) includes a first source/drain structure (151) and a second source/drain structure (152) spaced apart from each other, and
wherein the semiconductor device further includes a first upper contact electrode (UCT1) disposed on the first source/drain structure and connected to the first source/drain structure.

13. The semiconductor device of claim 12, wherein the lower contact electrode (CT1) is disposed under the second source/drain structure (152) and connected to the second source/drain structure.

14. The semiconductor device of claim 12 or 13, wherein the semiconductor device further includes a second upper contact electrode (UCT2) disposed on the gate pattern (GS) and connected to the gate pattern.

15. The semiconductor device of any of claims 12 to 14, wherein
the semiconductor device further includes a lower insulating layer (330) disposed under the lower pattern layer (110), and
the lower contact electrode (CT1) is connected to the source/drain pattern (150) by penetrating the lower insulating layer.
